(19) **Europäisches Patentamt / European Patent Office / Office européen des brevets**

(11) **EP 4 787 421 A1**

(12) **EUROPEAN PATENT APPLICATION**
published in accordance with Art. 153(4) EPC

(43) Date of publication:
05.08.2026  Bulletin 2026/32

(21) Application number: 24871784.5

(22) Date of filing: 06.09.2024

(51) International Patent Classification (IPC):
*H01L 21/02* (2006.01)   *G09F 9/00* (2006.01)
*H01L 21/50* (2006.01)   *H01L 21/52* (2006.01)
*H01L 21/60* (2006.01)   *H01L 21/677* (2006.01)
*H10H 20/00* (2025.01)

(52) Cooperative Patent Classification (CPC):
G09F 9/00; H10H 20/00; H10P 72/30; H10P 95/00;
H10W 72/071; H10W 95/00

(86) International application number:
PCT/JP2024/031965

(87) International publication number:
WO 2025/069985 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.09.2023  JP 2023165113

(71) Applicant: Oki Electric Industry Co., Ltd.
Minato-ku
Tokyo 105-8460 (JP)

(72) Inventors:
• KAWADA, Hiroto
  Tokyo 105-8460 (JP)
• KOSAKA, Toru
  Tokyo 105-8460 (JP)
• SUZUKI, Takahito
  Tokyo 105-8460 (JP)
• NAKAI, Yusuke
  Tokyo 105-8460 (JP)
• MATSUOKA, Moeka
  Tokyo 105-8460 (JP)

(74) Representative: Betten & Resch
Patent- und Rechtsanwälte PartGmbB
Maximiliansplatz 14
80333 München (DE)

(54) **TRANSFER METHOD, METHOD FOR MANUFACTURING ELECTRONIC DEVICE, AND TRANSFER MEMBER**

(57)   An adherend is inhibited from being damaged when a transfer member is separated from the adherend. A transfer method includes pressing the transfer member (107) against the adherend (104) situated on a first base material (101) and thereby joining the transfer member (107) to the adherend (104), moving the transfer member (107) to separate from the first base material (101) and thereby separating the adherend (104) joined to the transfer member (107) from the first base material (101), moving the transfer member (107) and thereby bonding the adherend (104) to a second base material (110), moving the transfer member (107) to separate from the second base material (110) and thereby separating a second joint part (105b) from the adherend (104) while leaving a first joint part (105a) joined to the adherend (104), and thereafter moving the transfer member (107) to separate from the second base material (110) and thereby separating the first joint part (105a) from the adherend (104).

FIG. 16

**Description**

**TECHNICAL FIELD**

The present disclosure relates to a transfer method, a manufacturing method of an electronic device, and a transfer member.

**BACKGROUND ART**

Conventionally, there has been known a method of separating a composite integrated film (referred to also as an "adherend") formed on a growth substrate from the growth substrate by using a stamp (referred to also as a "transfer member"), placing the adherend in contact with a device substrate to join the adherend to the device substrate with intermolecular force, and separating the transfer member from the adherend (see Patent Reference 1, for example).

**PRIOR ART REFERENCE**

**PATENT REFERENCE**

Patent Reference 1: Japanese Patent Application Publication No. 2022-79295 (see Fig. 11 and paragraphs 0063 to 0067).

**SUMMARY OF THE INVENTION**

**PROBLEM TO BE SOLVED BY THE INVENTION**

However, there are cases where the adherend is damaged when the transfer member is separated from the adherend joined to the device substrate.

An object of the present disclosure is to provide a transfer method and a transfer member that make it possible to inhibit the adherend from being damaged when the transfer member is separated from the adherend.

Another object of the present disclosure is to provide a manufacturing method of an electronic device that makes it possible to inhibit the adherend from being damaged when the transfer member is separated from the adherend.

**MEANS FOR SOLVING THE PROBLEM**

A transfer method in the present disclosure is a method for transferring an adherend situated on a first base material onto a second base material. The transfer method includes pressing a transfer member including a first joint part and a second joint part against the adherend situated on the first base material and thereby elastically deforming the first joint part and joining the first joint part and the second joint part to the adherend, moving the transfer member to separate from the first base material and thereby separating the adherend from the first base material while leaving the first joint part and the second joint part joined to the adherend, moving the transfer member to approach the second base material and thereby bonding the adherend to the second base material, moving the transfer member to separate from the second base material and thereby separating the second joint part from the adherend while leaving the first joint part joined to the adherend; and moving the transfer member to further separate from the second base material after the separation of the second joint part and thereby separating the first joint part from the adherend.

A manufacturing method in the present disclosure is a method of manufacturing an electronic device. The manufacturing method includes pressing a transfer member including a first joint part and a second joint part against an adherend situated on a first base material and thereby elastically deforming the first joint part and joining the first joint part and the second joint part to the adherend; moving the transfer member to separate from the first base material and thereby separating the adherend from the first base material while leaving the first joint part and the second joint part joined to the adherend; moving the transfer member to approach a second base material and thereby bonding the adherend to the second base material; moving the transfer member to separate from the second base material and thereby separating the second joint part from the adherend while leaving the first joint part joined to the adherend; and moving the transfer member to further separate from the second base material after the separation of the second joint part and thereby separating the first joint part from the adherend while providing the adherend on the second base material.

A transfer member in the present disclosure includes a joint member that is pressed against an adherend and thereby joined to the adherend. The joint member includes a first joint part capable of joining to the adherend, and a second joint part capable of joining to the adherend when the first joint part has joined to the adherend. The joint member is configured so that the first joint part and the second joint part join to the adherend when the first joint part is pressed against the adherend and elastically deformed and the second joint part separates from the adherend when the pressing is removed and the first joint part recovers.

According to the present disclosure, it is possible to inhibit the adherend from being damaged when the transfer member is separated from the adherend.

BRIEF DESCRIPTION OF THE DRAWINGS

Fig. 1 is a schematic cross-sectional view showing a growth substrate (first base material) used for forming an adherend as a transfer object in a transfer method (manufacturing method of an electronic device) according to a first embodiment;

Figs. 2(A) and 2(B) are a schematic cross-sectional view and a schematic plan view showing an epitaxial layer formed on a semiconductor wafer as the growth substrate;

Figs. 3(A) and 3(B) are a schematic cross-sectional view and a schematic plan view showing a process of forming the adherend including a semiconductor layer;

Fig. 4 is a schematic perspective view showing an example of a composite integrated film as the adherend;

Fig. 5 is a schematic plan view showing a semiconductor wafer on which a plurality of adherends have been formed;

Fig. 6 is a schematic perspective view showing a stamp as a transfer member used in the transfer method according to the first embodiment;

Fig. 7 is a schematic cross-sectional view showing an etching process of the growth substrate (part under the adherend);

Fig. 8 is a schematic cross-sectional view showing a state after the etching process of Fig. 7;

Fig. 9 is a schematic cross-sectional view showing a process of joining a first joint part of a joint member (elastic body) of the stamp according to the first embodiment to the adherend;

Fig. 10 is an explanatory drawing showing maximum surface roughness of a contact surface of the joint member of the stamp and maximum surface roughness of the adherend;

Fig. 11 is a schematic cross-sectional view showing a process of joining a second joint part of the joint member of the stamp according to the first embodiment to the adherend;

Fig. 12 is a schematic cross-sectional view showing a process (part 1) of moving the joint member of the stamp according to the first embodiment in the state of having been joined to the adherend;

Fig. 13 is a schematic cross-sectional view showing the process (part 2) of moving the joint member of the stamp according to the first embodiment in the state of having been joined to the adherend;

Fig. 14 is a schematic cross-sectional view showing the process (part 3) of moving the joint member of the stamp according to the first embodiment in the state of having been joined to the adherend;

Fig. 15 is a schematic cross-sectional view showing a process (part 1) of bonding the adherend to a device substrate (second base material) by using the stamp according to the first embodiment;

Fig. 16 is a schematic cross-sectional view showing the process (part 2) of bonding the adherend to the device substrate by using the stamp according to the first embodiment;

Fig. 17 is a schematic cross-sectional view showing a process (part 1) of separating the stamp according to the first embodiment from the adherend bonded to the device substrate;

Fig. 18 is a schematic cross-sectional view showing the process (part 2) of separating the stamp according to the first embodiment from the adherend bonded to the device substrate;

Figs. 19(A) and 19(B) are a schematic cross-sectional view and a schematic plan view showing the shape and dimensions of the joint member (elastic body) of the stamp according to the first embodiment;

Fig. 20 is a block diagram showing the general configuration of a device that executes the transfer method according to the first embodiment;

Fig. 21 is a flowchart showing the transfer method according to the first embodiment;

Fig. 22 is a schematic perspective view showing a stamp as a transfer member used in a transfer method (manufacturing method of an electronic device) according to a second embodiment;

Fig. 23 is a schematic perspective view showing another stamp used in the transfer method according to the second embodiment;

Fig. 24 is a schematic cross-sectional view showing a process of joining a first joint part of a joint member of the stamp according to the second embodiment to the adherend;

Fig. 25 is a schematic cross-sectional view showing a process of joining a second joint part of the joint member of the stamp according to the second embodiment to the adherend;

Fig. 26 is a schematic cross-sectional view showing a process (part 1) of moving the joint member of the stamp according to the second embodiment in the state of having been joined to the adherend;

Fig. 27 is a schematic cross-sectional view showing the process (part 2) of moving the joint member of the stamp according to the second embodiment in the state of having been joined to the adherend;

Fig. 28 is a schematic cross-sectional view showing the process (part 3) of moving the joint member of the stamp according to the second embodiment in the state of having been joined to the adherend;

Fig. 29 is a schematic cross-sectional view showing a process (part 1) of bonding the adherend to the device substrate (second base material) by using the stamp according to the second embodiment;

Fig. 30 is a schematic cross-sectional view showing the process (part 2) of bonding the adherend to the device substrate (second base material) by using the stamp according to the second embodiment;

Fig. 31 is a schematic cross-sectional view showing a process (part 1) of separating the stamp according to the second embodiment from the adherend bonded to the device substrate;

Fig. 32 is a schematic cross-sectional view showing the process (part 2) of separating the stamp according to the second embodiment from the adherend bonded to the device substrate;

Fig. 33 is a schematic cross-sectional view showing the shape and dimensions of the joint member of the stamp according to the second embodiment;

Fig. 34 is a schematic perspective view showing a stamp as a transfer member used in a transfer method (manufacturing method of an electronic device) according to a third embodiment;

Fig. 35 is a schematic cross-sectional view showing a process of joining a first joint part of a joint member of the stamp according to the third embodiment to the adherend;

Fig. 36 is a schematic cross-sectional view showing a process of joining a second joint part of the joint member of the stamp according to the third embodiment to the adherend;

Fig. 37 is a schematic cross-sectional view showing a process (part 1) of moving the joint member of the stamp according to the third embodiment in the state of having been joined to the adherend;

Fig. 38 is a schematic cross-sectional view showing the process (part 2) of moving the joint member of the stamp according to the third embodiment in the state of having been joined to the adherend;

Fig. 39 is a schematic cross-sectional view showing the process (part 3) of moving the joint member of the stamp according to the third embodiment in the state of having been joined to the adherend;

Fig. 40 is a schematic cross-sectional view showing a process (part 1) of bonding the adherend to the device substrate (second base material) by using the stamp according to the third embodiment;

Fig. 41 is a schematic cross-sectional view showing the process (part 2) of bonding the adherend to the device substrate by using the stamp according to the third embodiment;

Fig. 42 is a schematic cross-sectional view showing a process (part 1) of separating the stamp according to the third embodiment from the adherend bonded to the device substrate;

Fig. 43 is a schematic cross-sectional view showing the process (part 2) of separating the stamp according to the third embodiment from the adherend bonded to the device substrate;

Fig. 44 is a schematic cross-sectional view showing the shape and dimensions of the joint member of the stamp according to the third embodiment;

Fig. 45 is a schematic cross-sectional view showing a process of joining a first joint part of a joint member of a stamp as a transfer member used in a transfer method (manufacturing method of an electronic device) according to a fourth embodiment to the adherend;

Fig. 46 is a schematic cross-sectional view showing a process of joining a second joint part of the joint member of the stamp according to the fourth embodiment to the adherend;

Fig. 47 is a schematic cross-sectional view showing a process (part 1) of moving the joint member of the stamp according to the fourth embodiment in the state of having been joined to the adherend;

Fig. 48 is a schematic cross-sectional view showing the process (part 2) of moving the joint member of the stamp according to the fourth embodiment in the state of having been joined to the adherend;

Fig. 49 is a schematic cross-sectional view showing the process (part 3) of moving the joint member of the stamp according to the fourth embodiment in the state of having been joined to the adherend;

Fig. 50 is a schematic cross-sectional view showing a process (part 1) of bonding the adherend to the device substrate by using the stamp according to the fourth embodiment;

Fig. 51 is a schematic cross-sectional view showing the process (part 2) of bonding the adherend to the device substrate by using the stamp according to the fourth embodiment;

Fig. 52 is a schematic cross-sectional view showing a process (part 1) of separating the stamp according to the fourth embodiment from the adherend bonded to the device substrate; and

Fig. 53 is a schematic cross-sectional view showing the process (part 2) of separating the stamp according to the fourth embodiment from the adherend bonded to the device substrate.

**MODE FOR CARRYING OUT THE INVENTION**

A transfer method, a manufacturing method of an electronic device, and a transfer member according to each embodiment of the present disclosure will be described below with reference to the drawings. The following embodiments are just examples and it is possible to appropriately combine embodiments and appropriately modify each embodiment.

Coordinate axes of an xyz orthogonal coordinate system are shown in the drawings in order to facilitate the understanding of relationship between drawings. An x-axis and a y-axis are coordinate axes in directions parallel to a surface of a growth substrate as a first base material or a surface of a device substrate as a second base material. A z-axis is a coordinate axis in a thickness direction (i.e., height direction or depth direction) of a stamp as a transfer member. Further, a -z direction is referred to also as a first direction.

A transfer method according to each embodiment is a method of transferring an adherend (e.g., structure) situated on the first base material onto the second base material by using the transfer member that can be moved by a transfer device. The adherend is a structure, for example. The structure is a material that does not have its own function, such as a semiconductor film including an epitaxial growth film, for example.

The adherend can be a functional unit including a semiconductor device, for example. The functional unit is a material having a function and including metal and an organic material besides a semiconductor film, such as a composite integrated film and a wafer, for example.

A manufacturing method of an electronic device according to each embodiment is a method of transferring the adherend situated on the first base material onto the second base material by using the transfer member that can be moved by the transfer device. The adherend is a semiconductor film including an epitaxial growth film, for example. The electronic device can be a μLED display including a plurality of μLEDs (micro light-emitting diodes), a light source device including a μLED, or the like.

A transfer member according to each embodiment includes a joint member that joins to the adherend. The joint member includes a first joint part (first joint region) and a second joint part (second joint region), joins to the adherend situated on the first base material, separates the adherend from the first base material, and transfers the adherend onto the second base material. The transfer member includes, for example, the joint member as an elastic body and a support that supports the joint member. The joint member supported by the support is desired to be formed integrally by using the same material. However, it is also possible to form the joint member with a combination of different materials. For example, in the joint member, a pedestal part on the support's side and a deforming part on the adherend's side may be respectively formed with different materials. The support is formed with a material harder than the joint member.

(1) First Embodiment

(1-1) Adherend and Stamp (Transfer Member)

A description will be given below of the adherend (e.g., structure) as a transfer object transferred by a transfer method according to a first embodiment.

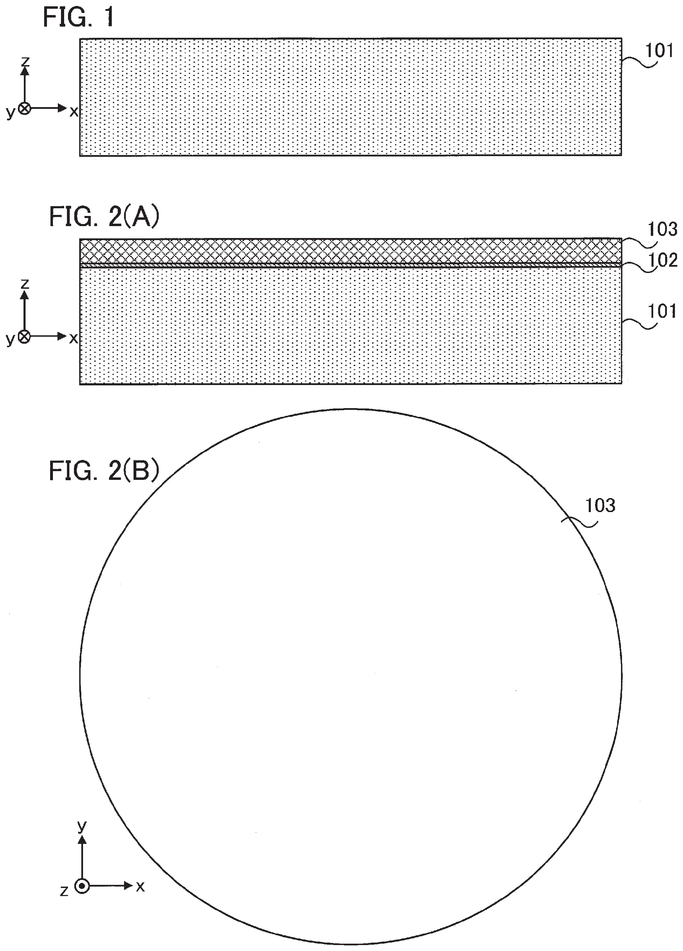

Fig. 1 is a schematic cross-sectional view showing a growth substrate 101 as the first base material used for forming the adherend 104 as the transfer object in the transfer method according to the first embodiment. The growth substrate 101 is, for example, a silicon substrate whose crystal growth surface (upper surface in Fig. 1) is a (111) surface, namely, a Si (111) substrate.

Figs. 2(A) and 2(B) are a schematic cross-sectional view and a schematic plan view showing an epitaxial layer formed on a semiconductor wafer as the growth substrate 101. As shown in Fig. 2(A) or 2(B), an epitaxial growth film (referred to also as a "semiconductor film") is formed by epitaxially growing an AlN (aluminum nitride) layer 102 as a buffer layer on the growth substrate 101 and epitaxially growing a GaN (gallium nitride) layer 103 on the AlN layer 102. The structure of the laminated semiconductor as the epitaxial growth film is not limited to that in the illustrated example. The epitaxial growth film may include three or more semiconductor layers. The layers epitaxially grown can also be, for example, layers including an AlGaAs (aluminum gallium arsenide) layer, an AlInGaP (aluminum indium gallium phosphorous) layer, an InP (indium phosphorous) layer or a Si (silicon) layer besides the GaN layer.

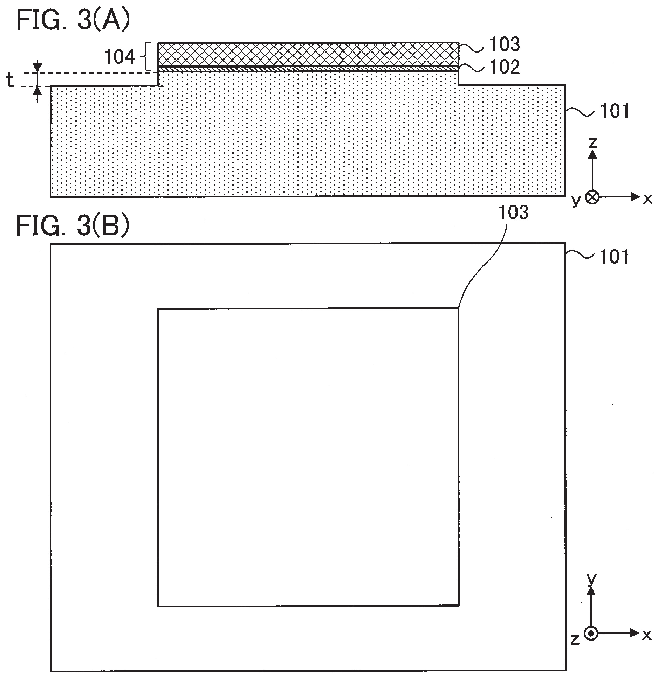

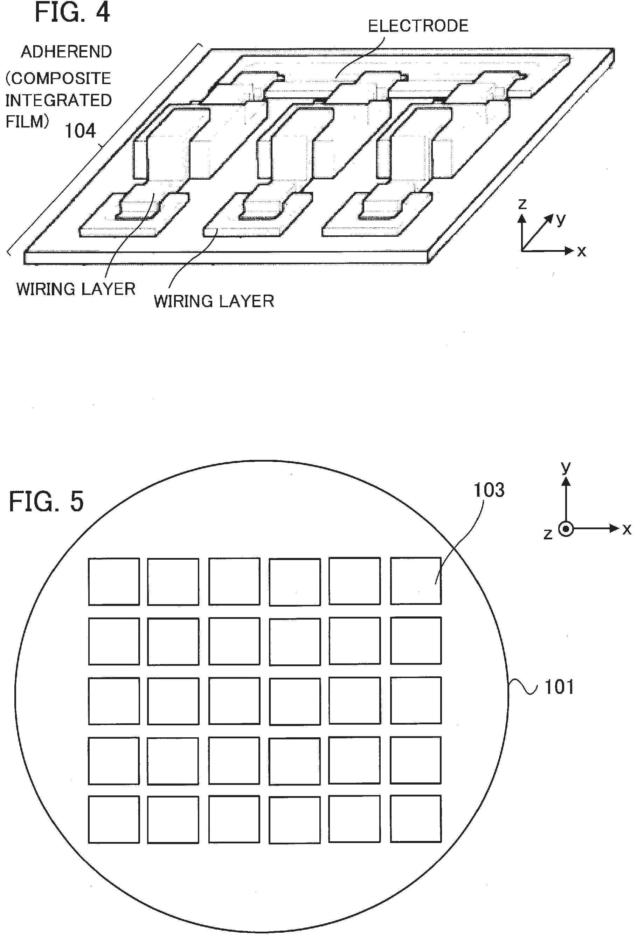

Figs. 3(A) and 3(B) are a schematic cross-sectional view and a schematic plan view showing a process of forming the adherend 104 including a semiconductor layer. Fig. 4 is a schematic perspective view showing an example of a composite integrated film as the adherend 104. Fig. 5 is a schematic plan view showing a semiconductor wafer on which a plurality of adherends 104 have been formed. The adherend 104 as a structure in an element geometry shown in Figs. 3(A) and 3(B) and Fig. 5 is formed by forming a photoresist (not shown) for patterning on the upper surface of the laminated semiconductor shown in Fig. 2(A) and executing the patterning into the element geometry by means of dry etching. In the patterning, the laminated semiconductor is etched to the growth substrate 101 that is the Si substrate. An overetching length t in this case is in a range of 50 nm to 10000 nm. As shown in Fig. 5, a plurality of adherends arranged regularly (e.g., in a matrix) are formed on the semiconductor wafer.

The adherend 104 can be a composite integrated film like the one shown in Fig. 4. The composite integrated film has a configuration in which a plurality of components (e.g., wiring layer, electrode layer, etc.) are set on a base material thin film. The transfer of the adherend 104 is possible irrespective of whether the surface of the adherend 104 is uneven or flat. A desirable shape of the adherend 104 is a shape whose surface is a flat surface having high smoothness.

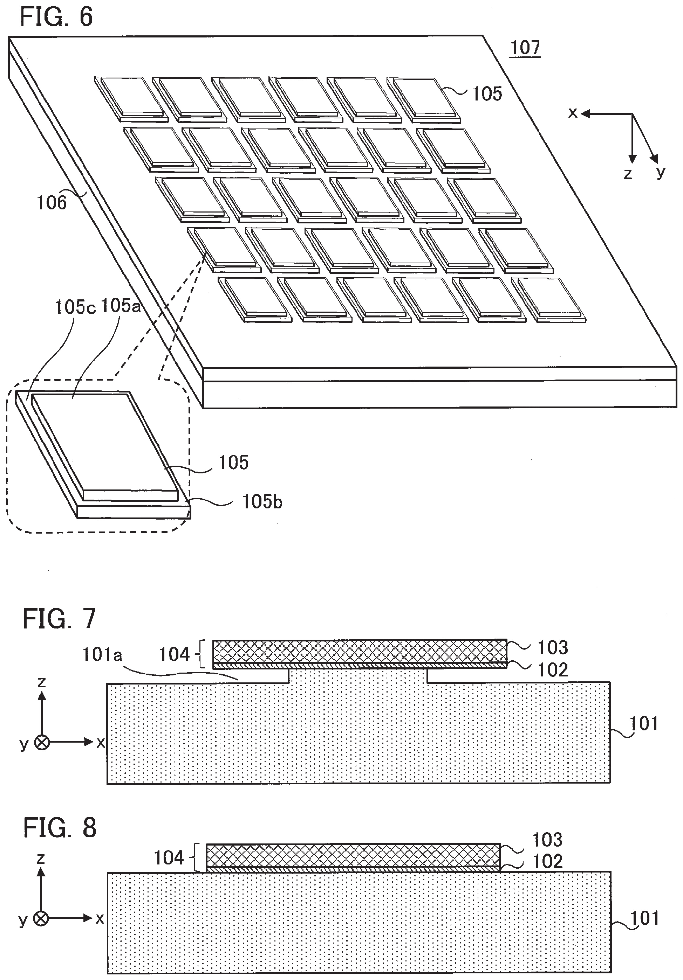

Fig. 6 is a schematic perspective view showing a stamp 107 as the transfer member used in the transfer method according to the first embodiment. The stamp 107 in Fig. 6 includes a plurality of joint members (elastic bodies) 105 formed at positions corresponding to the plurality of adherends 104 in Fig. 5 and a support 106 that supports the plurality of joint members 105. As shown in Fig. 6, the joint member 105 includes a first joint part 105a in a convex shape projecting in the -z direction (i.e., being high in the -z direction) and a second joint part 105b that is lower than the first joint part 105a. Namely, a concave part 105c is formed on a -z direction side of the second joint part 105b. The first joint part 105a is a part constantly joined to the adherend 104 in the transfer process except for processes in which the joint member 105 is separated from the adherend 104. A contact surface of the second joint part 105b is formed to be closer to the support 106 compared to a contact surface of the first joint part 105a. The second joint part 105b is joined to the adherend 104 when the adherend 104 is separated from the growth substrate 101 and when the adherend 104 is joined to a device substrate 110. The joint member 105 is a part for picking up the adherend 104 as a semiconductor thin film. The joint member 105 is formed with silicone such as PDMS (polydimethylsiloxane), for example. The support 106 is formed with a material having rigidity and being harder than the joint member 105. A glass substrate or the like can be employed as the support 106.

Fig. 7 is a schematic cross-sectional view showing an etching process of the growth substrate 101. Fig. 8 is a schematic cross-sectional view showing a state after the etching process of Fig. 7. A part of the growth substrate 101 (the part indicated by the reference character 101a) is etched in a horizontal direction as shown in Fig. 7 by performing anisotropic etching on the growth substrate 101 shown in Fig. 3(A) by using an etching solution such as a potassium hydroxide (KOH) aqueous solution. Consequently, as shown in Fig. 8, a sacrificial layer part is etched and the AlN layer 102 of the adherend 104 is set on the growth substrate 101 in a separate state of not having been joined to the growth substrate 101.

The configuration of the adherend 104 is not limited to the AlN layer 102 as the buffer layer on the growth substrate 101 and the GaN layer 103; it is also possible, for example, to form an AlAs layer as the sacrificial layer and epitaxially grow an AlGaAs layer or an AlInGaP layer on the AlAs layer. In this case, hydrochloric acid or hydrofluoric acid can be used for the etching of the sacrificial layer, for example.

Further, the adherend 104 can also be a composite integrated film obtained by, for example, integrating an organic film, a semiconductor film and an inorganic film together on a sacrificial layer made of $Al_2O_3$, Al, Ti, Au, AuGeNi or the like. In this case, hydrochloric acid, hydrofluoric acid, phosphoric acid, an iodine-based etchant or the like can be used for the etching of the sacrificial layer, for example.

Incidentally, the thickness of the adherend 104 is desired to be 1 to 100 $\mu$m.

(1-2) Transfer Method

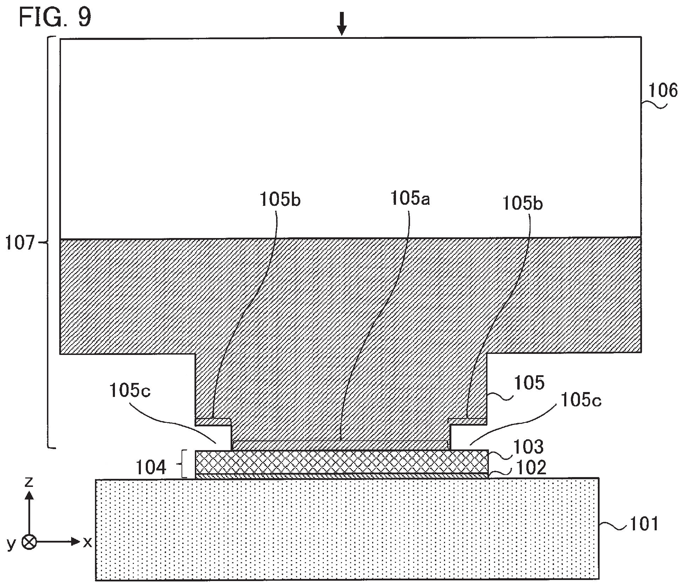

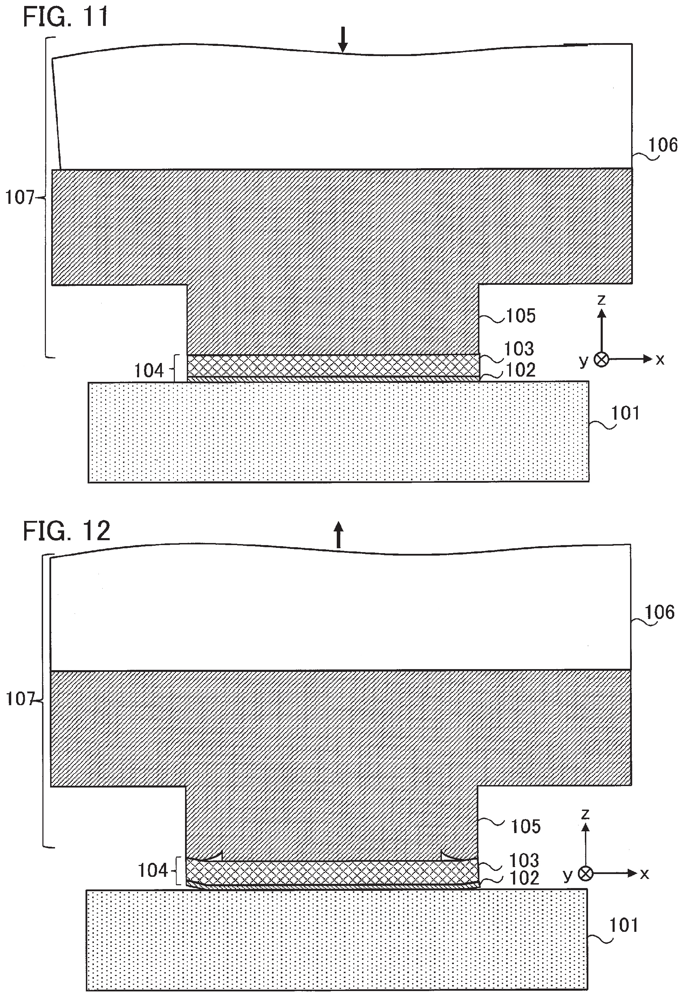

Fig. 9 is a schematic cross-sectional view showing a process of joining the first joint part 105a of the joint member 105 of the stamp 107 according to the first embodiment to the adherend 104. Fig. 11 is a schematic cross-sectional view showing a process of joining the second joint part 105b of the joint member 105 of the stamp 107 to the adherend 104. As shown in Fig. 9, the stamp 107 including the first joint part 105a and the second joint part 105b is pressed against the adherend 104 situated on the growth substrate 101, by which the first joint part 105a is elastically deformed and the first joint part 105a and the second joint part 105b are joined to the adherend 104 as shown in Fig. 11.

The stamp 107 is placed in contact with the adherend 104 as shown in Fig. 9, and the area $S_1$ of a contacting region of the first joint part 105a of the joint member 105 at that time is 1666 $\mu$m$^2$. When the stamp 107 is moved further downward (in the -z direction) as shown in Fig. 11, the second joint part 105b of the joint member 105 makes contact with the adherend 104. At that time, the area S of a region where the first joint part 105a and the second joint part 105b of the joint member 105 added together contact the adherend 104 is 2500 $\mu$m$^2$, for example. As above, the area of the region where the adherend 104 and the joint member 105 contact each other in Fig. 9 is smaller than the area of the region where the adherend 104 and the joint member 105 contact each other in Fig. 11.

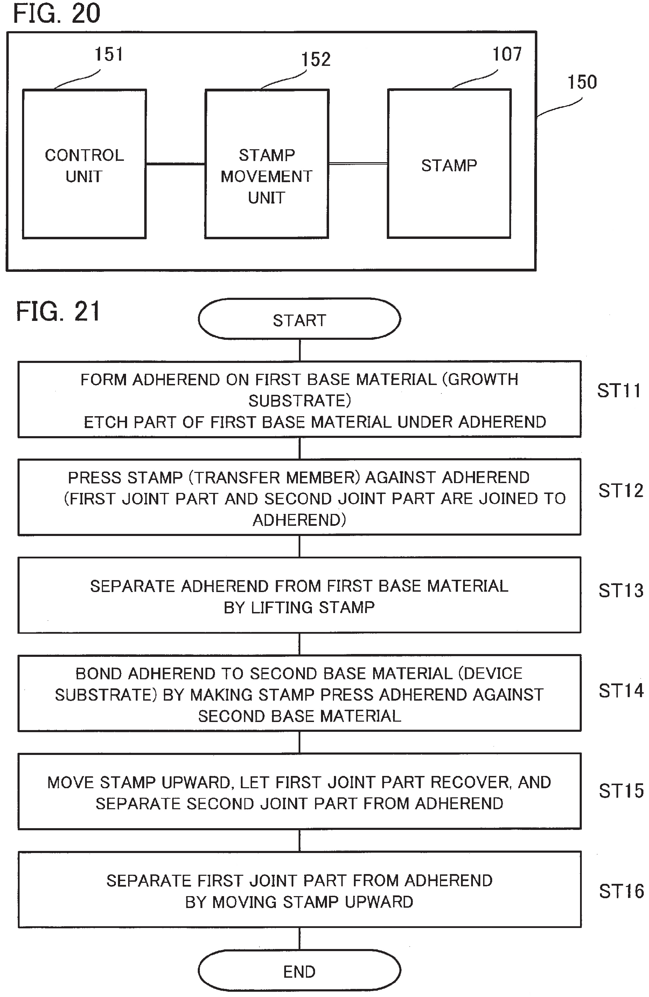

A movement amount (moving distance) of moving the joint member 105 to elastically deform the joint member 105 and place the entirety of the first joint part 105a and the second joint part 105b in close contact with the adherend 104 as shown in Fig. 11 is previously adjusted based on an experiment or the like, and is controlled by the transfer device (shown in Fig. 20 which will be explained later) storing the movement amount. The joint member 105 is formed with a material having stretchability and flexibility such as PDMS. PDMS has a delayed elastic recovery property, with which rapid deformation recovery does not occur and the joint member 105 recovers substantially to the original shape after the elapse of a prescribed time when the joint member 105 is deformed greatly and thereafter the stress is released.

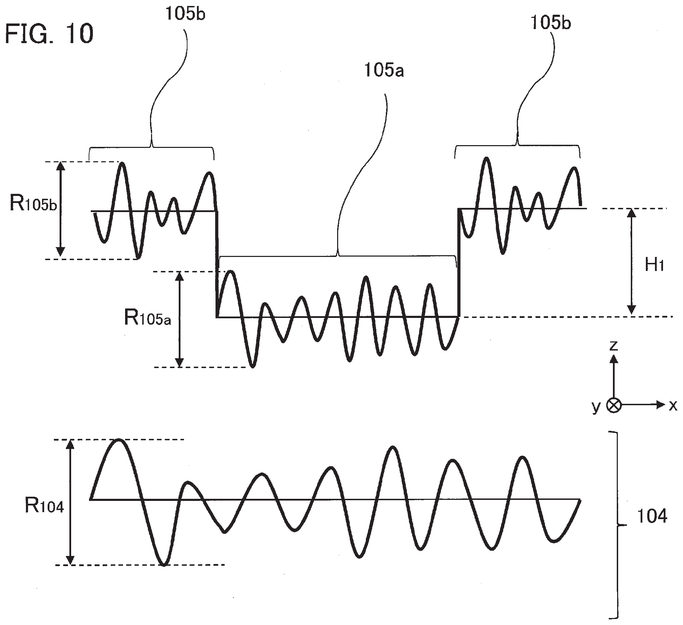

Fig. 10 is an explanatory drawing showing maximum surface roughness of the contact surface of the joint member 105 of the stamp 107 and maximum surface roughness of the adherend. The maximum surface roughness $R_{104}$

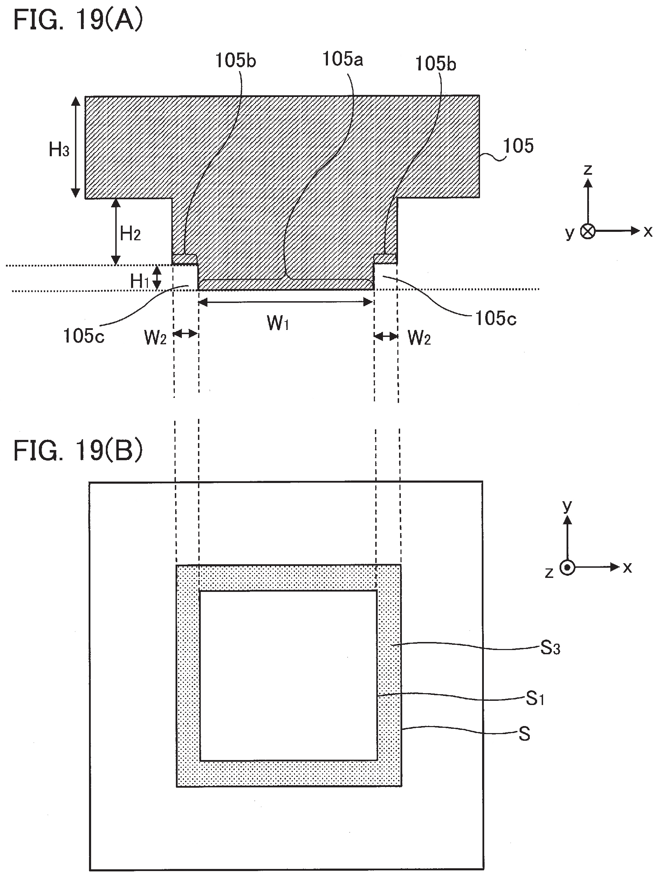

of an adhered surface (upper surface in Fig. 9) of the adherend 104 is desired to be less than or equal to 1/10 of the maximum surface roughness $R_{105a}$ of the contact surface of the first joint part 105a of the joint member 105 of the stamp 107 that makes contact with the adhered surface of the adherend 104. Further, the maximum surface roughness $R_{104}$ is desired to be less than or equal to 1/10 of the maximum surface roughness $R_{105b}$ of the contact surface of the second joint part 105b of the joint member 105 of the stamp 107 that makes contact with the adhered surface of the adherend 104. Each maximum surface roughness $R_{105a}$, $R_{105b}$ is defined as a level difference between a part most projecting in the +z direction and a part most projecting in the -z direction on the contact surface (front surface) of the joint member 105. The maximum surface roughness $R_{104}$ is defined as a level difference between a part most projecting in the +z direction and a part most projecting in the -z direction on the adhered surface (front surface) of the adherend 104. Further, each of the maximum surface roughness $R_{105a}$ and the maximum surface roughness $R_{105b}$ is desired to be less than a height $H_1$ shown in Fig. 19(A) which will be explained later.

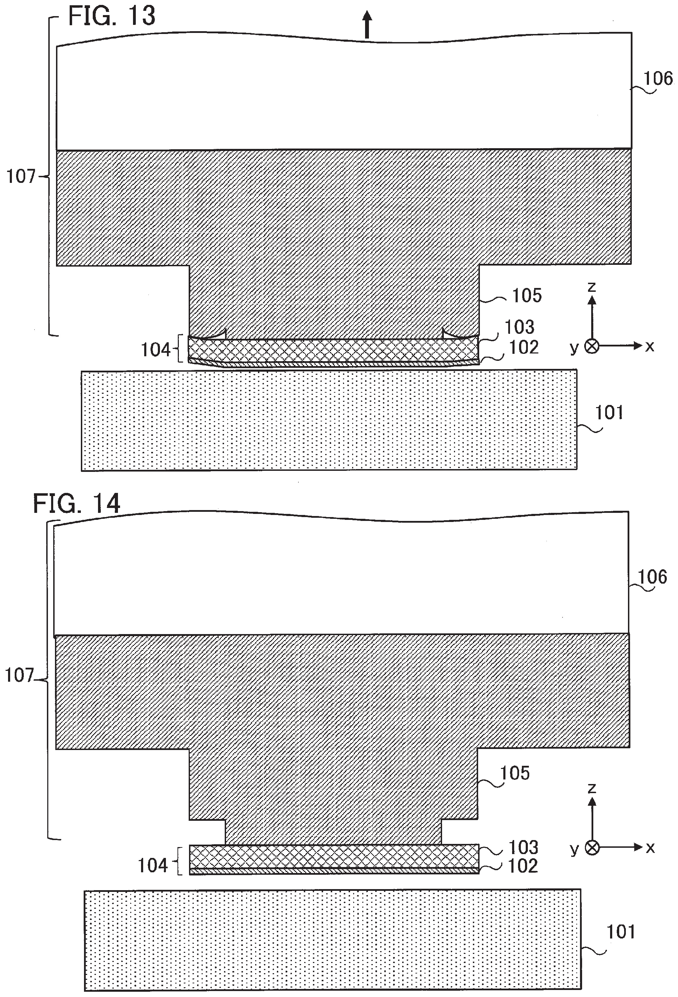

Figs. 12 to 14 are schematic cross-sectional views showing a process (part 1 - part 3) of moving the joint member 105 of the stamp 107 according to the first embodiment in the state of having been joined to the adherend 104. Fig. 12 shows a state when moving the stamp 107 upward (in the +z direction) is started. Fig. 13 shows a state when peeling the adherend 104 from the growth substrate 101 is started by moving the stamp 107 upward (in the +z direction). Fig. 14 shows a state when the joint member 105 has recovered to the original shape.

The stamp 107 is moved upward (in the +z direction) as shown in Fig. 12. At that time, the joint member 105 that has been pressed from above and elastically deformed stops receiving the pressure from above and begins to recover to the original shape. In this case, since an edge part of the joint member 105 has been placed in contact with the adherend 104 thanks to the deformation and has joined to the adherend 104 with adhesive force, the adherend 104 peels from the growth substrate 101 starting from the edge part of the adherend 104 as shown in Fig. 13. Each drawing is a schematic diagram, in which objects are drawn with certain deformation. Thereafter, as shown in Fig. 14, the joint of the edge part of the joint member 105 to the adherend 104 is also peeled while the edge part of the adherend 104 is peeled from the growth substrate 101 by deformation recovery due to its property; however, the peeling of the lower part of the adherend 104 and the growth substrate 101 is completed before the peeling of the edge part of the joint member 105.

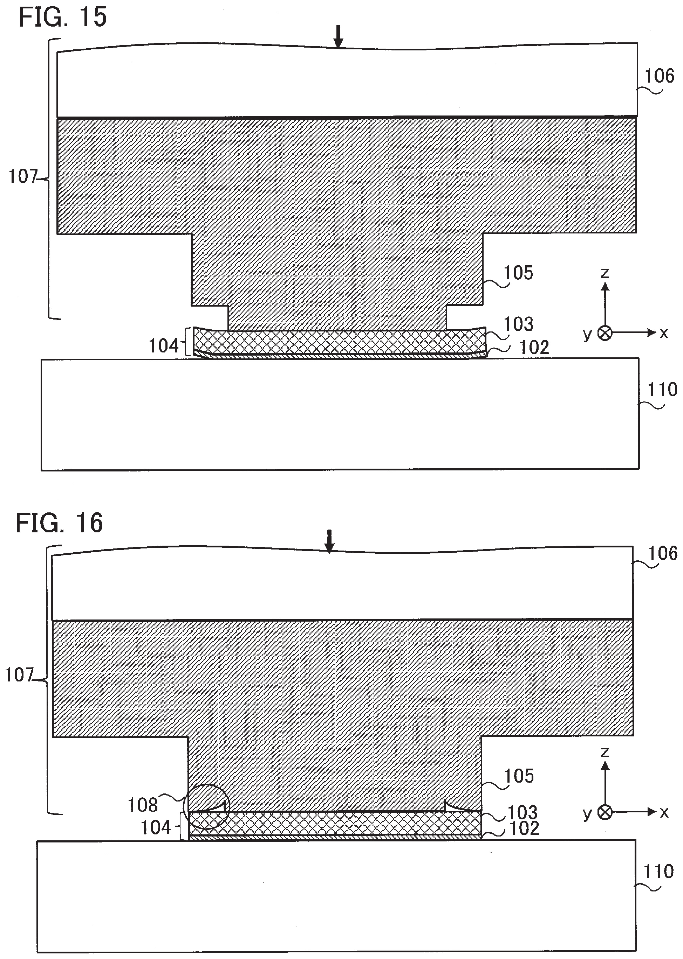

Fig. 15 and Fig. 16 are schematic cross-sectional views showing a process (part 1, part 2) of bonding the adherend 104 (e.g., functional unit) to the device substrate 110 (second base material) by using the stamp 107 according to the first embodiment. Fig. 15 shows a state when the adherend 104 is placed in contact with the device substrate 110. Fig. 16 shows a state in which the joint member 105 is deformed when the adherend 104 is stuck on the device substrate 110 by further applying a load from the state of Fig. 15.

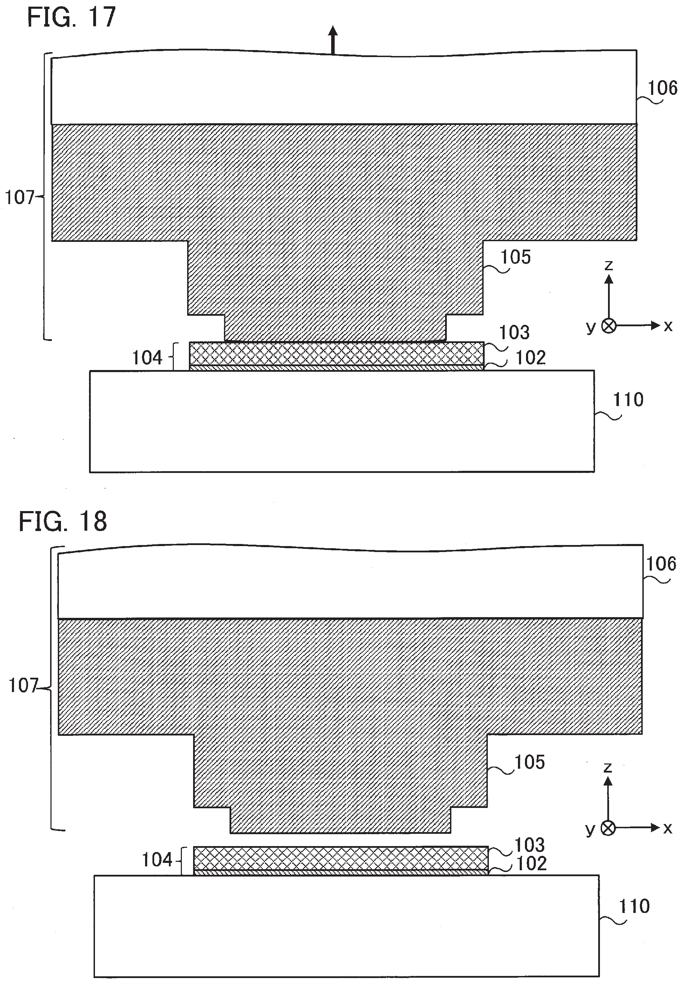

Fig. 17 and Fig. 18 are schematic cross-sectional views showing a process (part 1, part 2) of separating the stamp 107 according to the first embodiment from the adherend 104 bonded to the device substrate 110. Fig. 17 shows progress in which the stamp 107 after sticking the adherend 104 to the device substrate 110 is peeled from the adherend 104. Fig. 18 shows a state in which the stamp 107 after sticking the adherend 104 to the device substrate 110 has been separated from the adherend 104.

Figs. 19(A) and 19(B) are a schematic cross-sectional view and a schematic plan view showing the shape and dimensions of the joint member 105 of the stamp 107 according to the first embodiment.

As shown in Fig. 14, after the adherend 104 has been peeled off, the joint member 105 recovers to the original shape. For the adherend 104 that has been picked up, the first joint part 105a and the second joint part 105b of the joint member 105 of the stamp 107 recover to their original shapes and hold the adherend 104.

Subsequently, as shown in Fig. 15, the adherend 104 is transferred onto the device substrate 110 by using the stamp 107. Also at that time, the edge part of the joint member 105 is not in contact with the adherend 104, and thus the adherend 104 sticks to the device substrate 110 from a central part of the adherend 104. A contact area of the joint member 105 at that time is the area $S_1$ shown in Fig. 19(B) and is 1666 $\mu m^2$ in the first embodiment.

Further, as shown in Fig. 16, by applying downward force from above, the first joint part 105a and the second joint part 105b of the joint member 105 are deformed and pressed until making contact with the edge part of the adherend 104, by which also the second joint part 105b (the edge part in the first embodiment) is placed in close contact with the device substrate 110. At that time, a contacting area of the joint member 105 is the area S shown in Fig. 19(B) and is 2500 $\mu m^2$ in the first embodiment. Therefore, the contacting area of the adherend 104 and the joint member 105 in Fig. 15 is smaller than the contacting area of the adherend 104 and the joint member 105 in Fig. 16.

Lastly, as shown in Fig. 17, the stamp 107 is moved upward (in the +z direction) and the second joint part 105b of the joint member 105 peels off starting from its edge. At that time, the edge part of the joint member 105 is situated on an inner side relative to the edge of the adherend 104, and thus the adherend 104 remains stable after the transfer, with no force applied thereto in the direction of peeling. Finally, as shown in Fig. 18, the stamp 107 is separated and the transfer is finished. When the stamp 107 is separated, the second joint part 105b having the width $W_2$ shown in Fig. 19(A) (edge region 108 of the joint member 105 in Fig. 16) separates from the edge part in the state in which the first joint part 105a having the width $W_1$ is in contact with the adherend 104 in an adhering part (namely, in the state in which the adherend 104 is pressed by the first joint part 105a having the width $W_1$), and accordingly, the deformation recovery occurs and thereafter the part having the width $W_1$ also peels off.

The joint member 105 in Fig. 19(A) is made of PDMS and has the following properties, for example:

Shore hardness: A = 55 [Hs]
Young's modulus: E = 3.0 [MPa]
vertical spring constant: k = 85 [N/m]
adhesive force: D = 0.1 [MPa]

Here, for example, a projected area of the joint member 105's part indicated by the width $W_2$ is assumed to be S in the following expression:

$$\{W_1 + (W_2 \times 2)\}^2 = S.$$

The area of the projecting part indicated by the width $W_1$ is assumed to be $S_1$ in the following expression:

$$S_1 = W_1 \times W_1 = S \times (2/3).$$

If the area S is 2500 $\mu m^2$, the area $S_1$ is 1666 $\mu m^2$. The area ratio $a_r$ between the area $S_1$ and the area S is $a_r = 2/3$, and the area $S_3$ of the concave part is $S_3 = S - S_1 = 834 \mu m^2$. Further, the height $H_1$ in Fig. 19(A) is 10 $\mu m$.

Force necessary for pressing and flattening the first joint part 105a as the region having the area $S_1$ can be obtained as follows:

$$repulsive\ force$$
$$= k\ (i.e.,\ vertical\ spring\ constant) \times H_1$$
$$= 85 \times 10 \times 10^{-6}\ [N]$$
$$= 8.5 \times 10^{-4}\ [N].$$

Repulsive pressure $S_3$ applied to the region having the area $S_3$ is obtained as follows:

$$repulsive\ pressure\ P_3$$
$$= (8.5 \times 10^{-4})/(834 \times 10^{-12})/10^{-6}$$
$$= 1.0\ [MPa].$$

Thus, it means that pressure of 1 MPa was applied per unit area in order to press and flatten the joint member 105 from the state of Fig. 9 to the state of Fig. 11. Then, in the process of peeling the stamp 107, when the edge part is peeled as shown in Fig. 12 and Fig. 13, force peeling the adherend 104 is applied to the edge part in a state in which the force lifting the stamp 107 upward (in the +z direction) is less than or equal to the adhesive force 0.1 MPa although it returns to the original condition when the stamp 107 is lifted upward (in the +z direction) with force exceeding the adhesive force 0.1 MPa.

By representing the relationship by expressions, the following expressions can be derived:

$$S_1 = a_r S \qquad\qquad (1)$$

$$S_3 = (1 - a_r) \times S \qquad\qquad (2)$$

$$K = E \cdot S_1/H \qquad\qquad (3)$$

$$F = k \cdot H_1 \qquad\qquad (4)$$

$$P = F/S_3 > D \qquad\qquad (5)$$

$$P = E \cdot S_1 \cdot H_1/S_3 \cdot H > D \qquad\qquad (6)$$

$$P = a_r \cdot E \cdot S \cdot H_1 / (1 - a_r) S \cdot H > D \qquad (7)$$

$$D < a_r \cdot E \cdot H_1 / (1 - a_r) H \qquad (8)$$

$$a_r \cdot E \cdot H_1 > D \cdot H - a_r \cdot D \cdot H \qquad (9)$$

$$a_r > D \cdot H / (E \cdot H_1 + D \cdot H) \qquad (10)$$

By deriving dimensions in the above expressions, values (unit: $\mu$m) in the following Table 1 are obtained:

| TABLE 1 | Max [$\mu$m] | Min [$\mu$m] |
|---|---|---|
| $H_3$ | 250 | 0.1 |
| $H_2$ | 100 | 10 |
| $H_1$ | 10 | 5 |
| $W_1$ | 46 | 14 |
| $W_2$ | 21 | 5 |

Further, $H_1$ and $H_2$ are desired to satisfy relationship of the following expression:

$$H_1 \times 20 \geq H_2 \geq H_1 \times 2.$$

For the weight of the joint member 105, adhesive force of the joint member 105 to the support 106 is sufficient, and thus the joint member 105 does not peel from the support 106 irrespective of the thickness of the joint member 105. Further, for the weight of the adherend 104, adhesive force of the joint member 105 to the adherend 104 is sufficient, and thus the adherend 104 does not peel from the joint member 105 irrespective of the thickness of the adherend 104.

Further, it is desirable that the width of the first joint part 105a be narrower than the width of the adherend 104 and the total value of the width $W_1$ of the first joint part 105a and the widths $W_2$ of the two second joint parts 105b in the x direction or the y direction ($W_1 + 2 \cdot W_2$ in Fig. 19(A)) be greater than or equal to the width of the adherend 104.

As described above, when peeling the adherend 104, the joint member 105 of the stamp 107 assumes the state in which the whole of the joint member 105 is deformed and making close contact with the adherend 104, and the peeling by weak force (less than or equal to 0.1 MPa) by the joint member 105 is performed on the entire upper surface of the adherend 104. At that time, the edge part of the adherend 104 is peeled without fail. Subsequently, the joint member 105 elastically deformed gradually recovers to the original shape while pulling the adherend 104 upward with strong force, by which the whole of the adherend 104 is peeled in a stable manner.

A part of the growth substrate 101 under the adherend 104 is etched, and joining force between the adherend 104 and the growth substrate 101 is sufficiently weaker than the adhesive force 0.1 MPa of PDMS. Further, joining force between the adherend 104 and the device substrate 110 is stronger than joining force between the stamp 107 and the adherend 104, and is greater than or equal to 0.1 MPa.

As described above, the stamp 107 is pulled upward from the state in which its concave part has been peeled naturally due to the elasticity of its convex part, by which the stamp 107 can be peeled from the adherend 104 without causing an outer periphery of the joint member 105 to pull the adherend 104.

Fig. 20 is a block diagram showing the general configuration of a transfer device 150 that executes the transfer method according to the first embodiment. As shown in Fig. 20, the transfer device 150 includes a control unit 151, a stamp movement unit 152 including a mechanism for moving the stamp 107, and the stamp 107. The control unit 151 includes a control circuit that controls the operation of the stamp movement unit 152. The control unit 151 can include a processor that operates according to a software program. The control unit 151 can also be a computer.

Fig. 21 is a flowchart showing the transfer method according to the first embodiment. First, the adherend 104 as the adherend is formed on the growth substrate 101 as the first base material and a part of the growth substrate 101 under the adherend 104 is etched (step ST11).

Subsequently, the transfer device 150 presses the stamp 107 including the first joint part 105a and the second joint part 105b against the adherend 104 situated on the growth substrate 101, thereby elastically deforming the first joint part 105a and joining the first joint part 105a and the second joint part 105b to the adherend 104 (step ST12).

Subsequently, the transfer device 150 separates the adherend 104 joined to the stamp 107 from the growth substrate 101 by moving (lifting in the first embodiment) the stamp 107 to separate from the growth substrate 101 (step ST13).

Subsequently, the transfer device 150 bonds the adherend 104 to the device substrate 110 by moving the stamp 107 (step ST14). The bonding is performed by using intermolecular binding force, without the need of using an adhesive agent.

Subsequently, the transfer device 150 moves the stamp 107 to separate from the device substrate 110 and thereby separates the second joint part 105b from the adherend 104 while leaving the first joint part 105a joined to the adherend 104 (step ST15).

Subsequently, the transfer device 150 after the separation of the second joint part 105b separates the first joint part 105a from the adherend 104 by moving the stamp 107 to separate from the device substrate 110 (step ST16).

Moving speed of the stamp 107 when the stamp 107 is moved to separate from the growth substrate 101 in the step ST13 is desired to be faster than the moving speed of the stamp 107 when the stamp 107 is moved to separate from the device substrate 110 in the steps ST15 and ST16.

In the step ST13, by setting the speed of separating from the growth substrate 101 to be fast, the adherend 104 can be peeled from the growth substrate 101 before the second joint part 105b peels naturally.

In contrast, after the adherend 104 is joined to the device substrate 110, the adherend 104 is slowly separated from the stamp 107, by which only the stamp 107 is peeled off after the second joint part 105b has peeled naturally. By this method, the adherend 104 can be joined to the device substrate 110 without damaging the edge part. Therefore, it is desirable to set a difference between the moving speeds.

(1-3) Effect

As described above, according to the first embodiment, the stamp 107 is formed with an elastic body such as PDMS and a step (level difference) is provided on the edge part of the stamp 107, by which occurrence of cracking in the edge part of the adherend 104 due to stress can be inhibited both when the adherend 104 is peeled from the growth substrate 101 and when the stamp 107 is peeled from the adherend 104 bonded to the device substrate 110. Further, it becomes possible to carry out the transfer starting from the edge part at the time of peeling and starting from the central part at the time of sticking.

(2) Second Embodiment

(2-1) Configuration and Operation

The formation flow of the adherend 104 shown in Fig. 1 to Fig. 5, Fig. 7 and Fig. 8, the block diagram of the transfer device 150 shown in Fig. 20, and the flowchart shown in Fig. 21 are employed also in a second embodiment. The second embodiment differs from the first embodiment in the structure of a stamp 207.

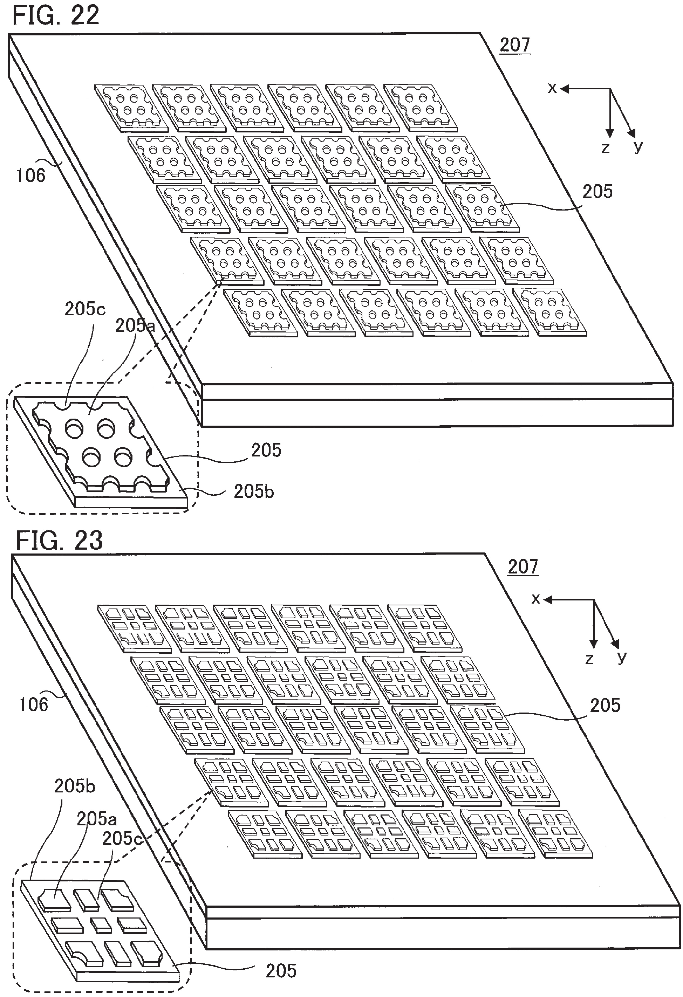

Fig. 22 is a schematic perspective view showing the stamp 207 as a transfer member used in a transfer method (manufacturing method of an electronic device) according to the second embodiment. Fig. 23 is a schematic perspective view showing another stamp 207 used in the transfer method according to the second embodiment. The stamp in Fig. 23 differs from the stamp in Fig. 22 whose concave part is a groove not penetrating, in that the concave part is in a shape of a penetrating groove. The stamp 207 in Fig. 22 or Fig. 23 includes a plurality of joint members (elastic bodies) 205 formed at positions corresponding to the plurality of adherends 104 in Fig. 5 and a support 106 that supports the plurality of joint members 205. As shown in Fig. 22 and Fig. 23, the joint member 205 includes a first joint part 205a in a convex shape projecting in the -z direction (i.e., being high in the -z direction) and a second joint part 205b that is lower than the first joint part 205a. Namely, a concave part 205c is formed on the -z direction side of the second joint part 205b. The concave part 205c has an inclined surface that becomes shallower as the position becomes closer to an edge part. The joint member 205 is a part for picking up the adherend 104 as the semiconductor thin film. The material of the joint member 205 is the same as that in the first embodiment.

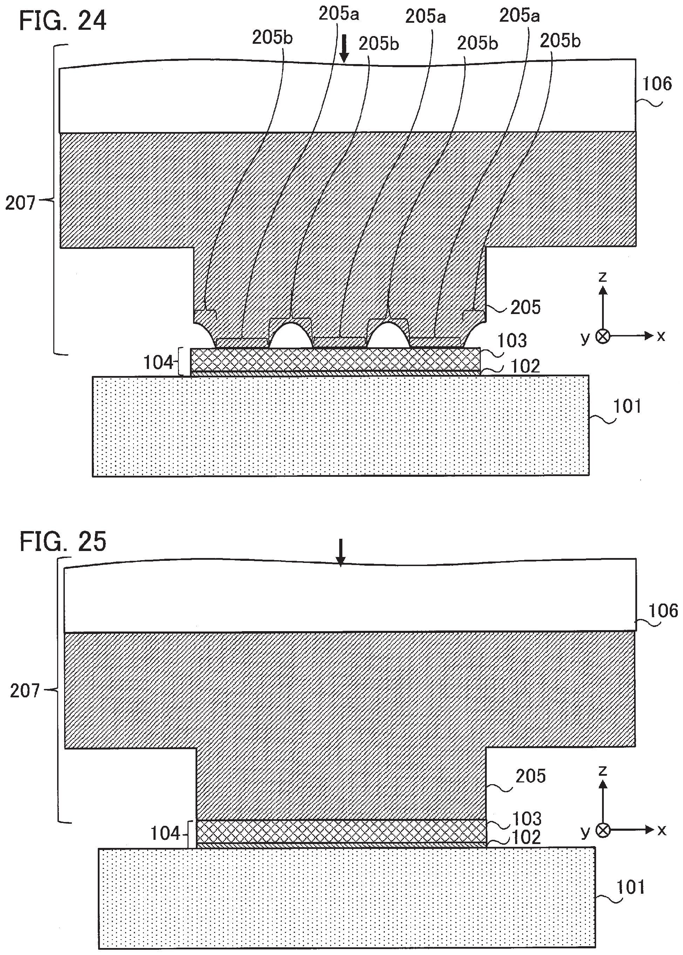

Fig. 24 is a schematic cross-sectional view showing a process of joining the first joint part 205a of the joint member 205 of the stamp 207 according to the second embodiment to the adherend 104. Fig. 24 shows a state in which the first joint part 205a of the joint member 205 has moved towards the adherend 104 and made contact with the adherend 104.

Fig. 25 is a schematic cross-sectional view showing a process of joining the second joint part 205b of the joint member 205 of the stamp 207 according to the second embodiment to the adherend 104. Fig. 25 is a diagram showing a state in which the joint member 205 has deformed and the second joint part 205b is in close contact with the adherend 104.

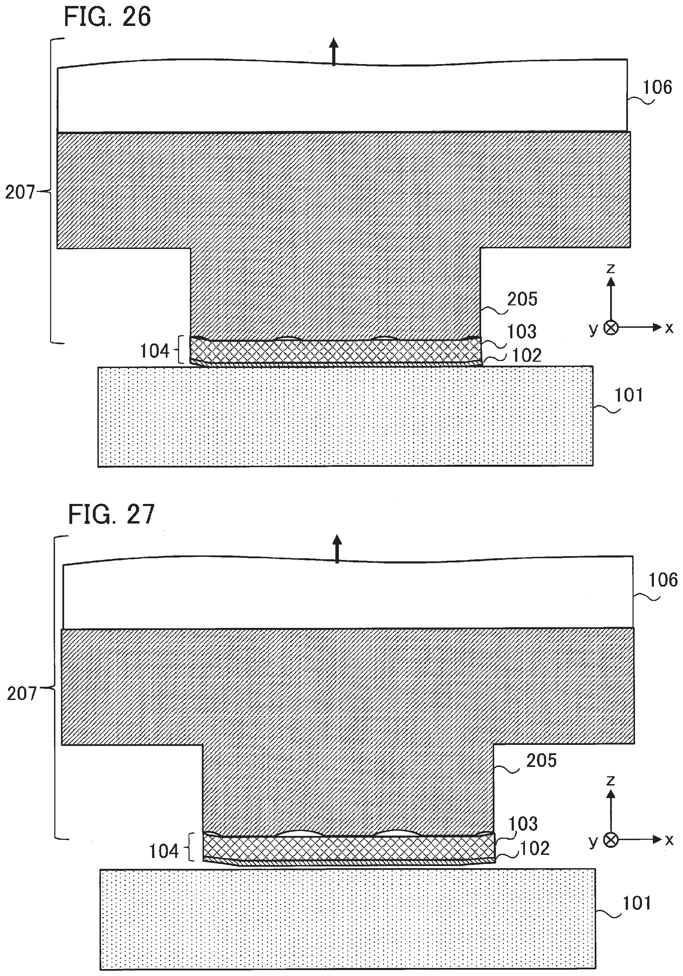

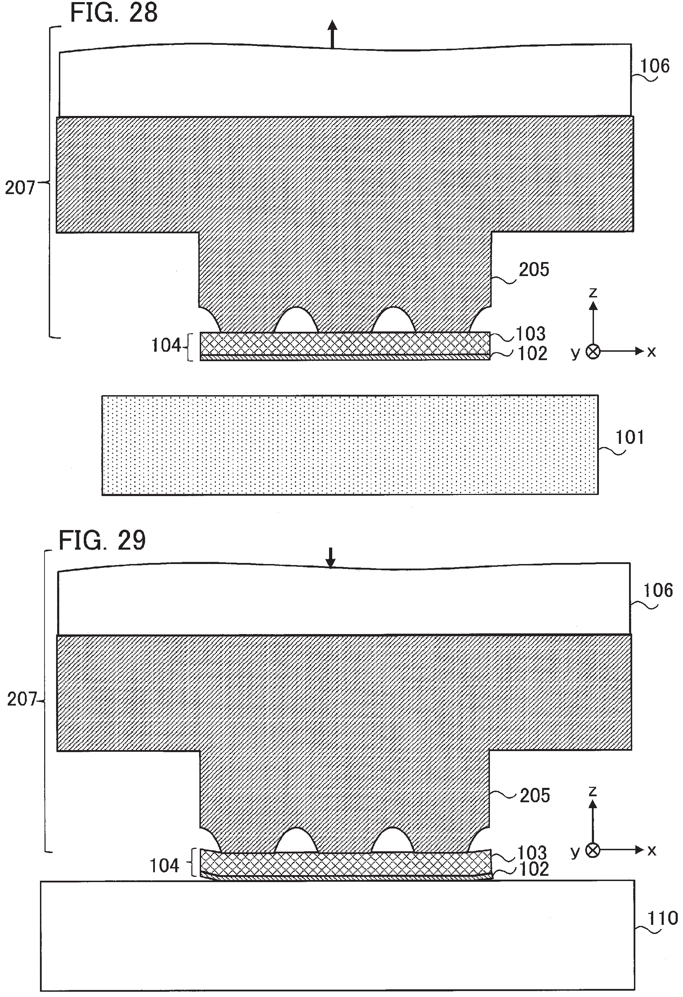

Figs. 26 to 28 are schematic cross-sectional views showing a process (part 1 - part 3) of moving the joint member 205 of the stamp 207 according to the second embodiment in the state of having been joined to the adherend 104. Fig. 26 shows a state when moving the stamp 207 upward (in the +z direction) is started. Fig. 27 shows a state when peeling the adherend 104 from the growth substrate 101 is started by moving the stamp 207 upward (in the +z direction). Fig. 28 shows a state when the joint member 205 has recovered to the original shape.

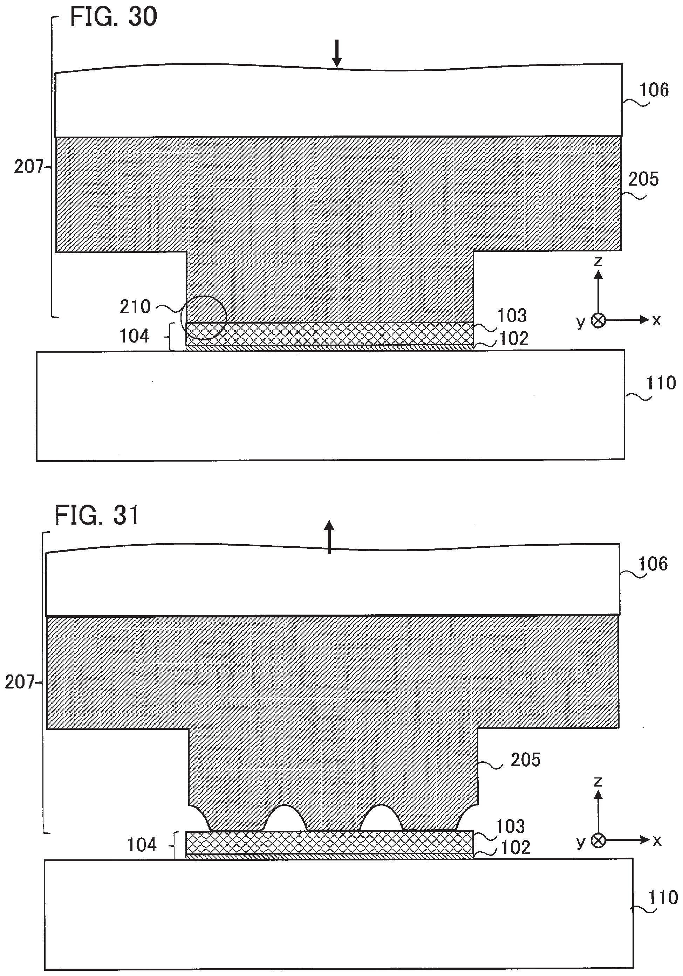

Fig. 29 and Fig. 30 are schematic cross-sectional views showing a process (part 1, part 2) of bonding the adherend 104 to the device substrate 110 (second base material) by using the stamp 207 according to the second embodiment. Fig. 29 shows a state when the adherend 104 is placed in contact with the device substrate 110. Fig. 30 shows a state in which the joint member 205 is deformed when the adherend 104 is stuck on the device substrate 110 by further applying a load from the state of Fig. 29.

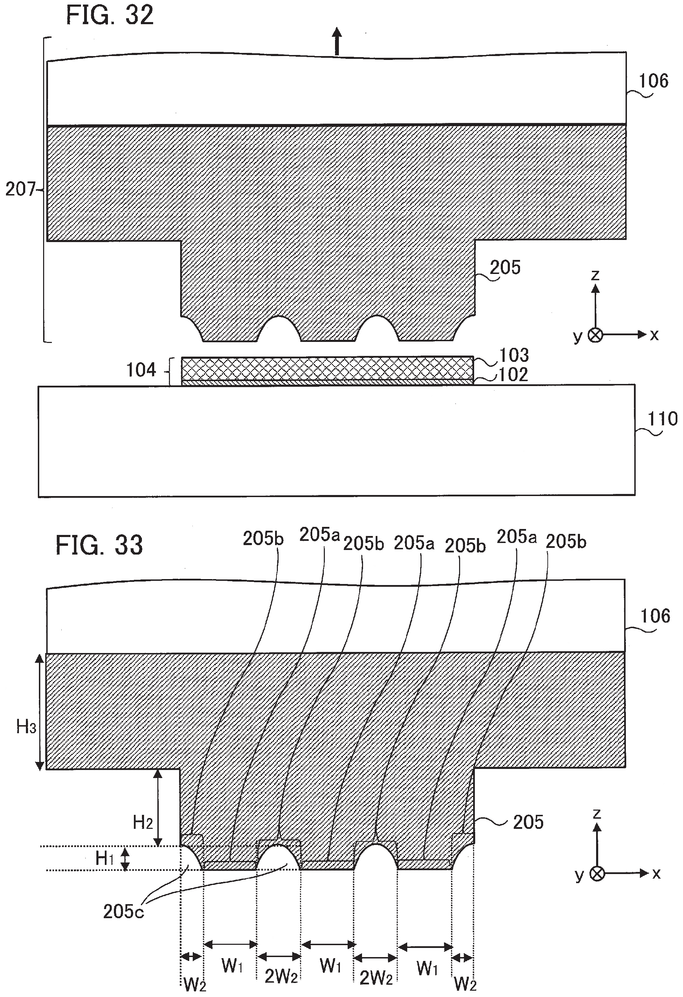

Fig. 31 and Fig. 32 are schematic cross-sectional views showing a process (part 1, part 2) of separating the stamp 207 according to the second embodiment from the adherend 104 bonded to the device substrate 110. Fig. 31 shows progress in which the stamp 207 after sticking the adherend 104 to the device substrate 110 is peeled from the adherend 104. Fig. 32 shows a state in which the stamp 207 after sticking the adherend 104 to the device substrate 110 has been separated from the adherend 104.

Fig. 33 is a schematic cross-sectional view showing the shape and dimensions of the joint member 205 of the stamp 207 according to the second embodiment.

In the second embodiment, first, as shown in Fig. 24, the stamp 207 formed with the joint member 205 and the support 106 is placed in contact with the adherend 104. Further, as shown in Fig. 25, the stamp 207 is moved downward (in the -z direction) until contact surfaces of the first joint part 205a and the second joint part 205b of the joint member 205 and the adherend 104 become parallel to each other. The movement amount of moving the joint member 205 to elastically deform the joint member 205 and place the joint member 205 in perfect contact with the adherend 104 as shown in Fig. 25 is adjusted based on result of a previously performed experiment or the like, and the transfer device 150 storing the movement amount moves the stamp 207. Similarly to the first embodiment, the contacting area of the joint member 205 and the adherend 104 in Fig. 24 is smaller than the contacting area of the joint member 205 and the adherend 104 in Fig. 25. The material of the joint member 205 is the same as that in the first embodiment.

Subsequently, as shown in Fig. 26, the stamp 207 is moved upward (in the +z direction). At that time, the joint member 205 that has been pressed from above and elastically deformed stops receiving the pressure from above and begins to recover to the original shape. In this case, since the edge part of the joint member 205 has been placed in contact with the adherend 104 thanks to the deformation and has joined to the adherend 104 with adhesive force, the adherend 104 peels from the growth substrate 101 starting from the edge part of the adherend 104. Since each drawing is a schematic diagram, objects are drawn with certain deformation. Thereafter, as shown in Fig. 27, the joint of the edge part of the joint member 205 to the adherend 104 is also peeled while the edge part of the adherend 104 is peeled from the growth substrate 101 by deformation recovery due to its property; however, the peeling of the lower part of the adherend 104 and the growth substrate 101 is completed before the peeling of the edge part of the joint member 205.

Subsequently, as shown in Fig. 28, after the adherend 104 has peeled, the joint member 205 recovers to the original shape. For the adherend 104 that has been picked up, the first joint part 205a and the second joint part 205b of the joint member 205 of the stamp 207 recover to their original shapes and hold the adherend 104.

Subsequently, as shown in Fig. 29, the adherend 104 is transferred onto the device substrate 110 by using the stamp 207. Also at that time, the edge part of the joint member 205 is not in contact with the adherend 104, and thus the adherend 104 sticks to the device substrate 110 from the central part of the adherend 104. Further, as shown in Fig. 30, by applying downward force from above, the first joint part 205a and the second joint part 205b of the joint member 205 are deformed and pressed until making contact with the edge part of the adherend 104, by which also the edge part is placed in close contact with the device substrate 110. Similarly to the first embodiment, the contacting area of the joint member 205 and the adherend 104 in Fig. 30 is larger than the contacting area of the joint member 205 and the adherend 104 in Fig. 31.

Lastly, as shown in Fig. 31, the stamp 207 is moved upward (in the +z direction) and the second joint part 205b of the joint member 205 peels starting from its edge. At that time, the edge contacting part of the joint member 205 is partially situated on the inner side relative to the edge of the adherend 104, and thus the adherend 104 remains stable after the transfer, with no force applied thereto in the direction of peeling. Finally, as shown in Fig. 32, the stamp 207 is separated and the transfer is finished. When the stamp 207 is separated, the second joint part 205b having the width $W_2$ shown in Fig. 33 (edge region 210 of the joint member 205 in Fig. 30) separates from the edge part in the state in which the first joint part 205a having the width $W_1$ is in contact with the adherend 104 in the adhering part (namely, in the state in which the adherend 104 is pressed by the first joint part 205a having the width $W_1$), and accordingly, the deformation recovery occurs and thereafter the part having the width $W_1$ also peels off.

The relationship among the dimensions $H_1$, $H_2$, $W_1$ and $W_2$ of the joint member 205 shown in Fig. 33 is similar to that in the first embodiment. Further, it is desirable that the total value of the widths of the first joint parts 205a be less than the width of the adherend 104 and the total value of the widths $W_1$ of the first joint parts 205a and the widths $W_2$ of the second joint parts 205b in the x direction or the y direction ($3 \cdot W_1 + 6 \cdot W_2$ in Fig. 33) be greater than or equal to the width of the adherend 104. Furthermore, for the weight of the joint member 205, the adhesive force of the joint member 205 to the support 106 is sufficient, and thus the joint member 205 does not peel from the support 106 irrespective of the thickness of the joint member 205. Moreover, for the weight of the adherend 104, the adhesive force of the joint member 205 to the adherend 104 is sufficient, and thus the adherend 104 does not peel from the joint member 205 irrespective of the thickness of the adherend 104.

As described above, when peeling the adherend 104, the joint member 205 of the stamp 207 assumes the state in which the whole of the joint member 205 is deformed and making close contact with the adherend 104, and the peeling by weak force (less than or equal to 0.1 MPa) by the joint member 205 is performed on the entire upper surface of the adherend 104. At that time, the edge part of the adherend 104 is peeled without fail. Subsequently, the joint member 205 elastically deformed gradually recovers to the original shape while pulling the adherend 104 upward with strong force, by which the whole of the adherend 104 is peeled in a stable manner.

The joining force between the adherend 104 and the growth substrate 101 after the part of the growth substrate 101 under the adherend 104 is removed is joining force sufficiently weaker than the adhesive force 0.1 MPa of PDMS. The joining force between the adherend 104 and the device substrate 110 is stronger than the joining force between the stamp 207 and the adherend 104, and is greater than or equal to 0.1 MPa.

As described above, the stamp 207 is pulled upward from the state in which the concave part as the second joint part 205b of the joint member 205 has been peeled naturally due to the elasticity of the convex part as the first joint part 205a of the joint member 205, by which the stamp 207 can be peeled from the adherend 104 without causing the outer periphery of the joint member 205 to pull the adherend 104.

(2-2) Effect

As described above, according to the second embodiment, in addition to the effect of the first embodiment, the contact area of the first joint part and the adherend 104 in Fig. 31 can be reduced and the occurrence of cracking due to stress can be inhibited also in the central part of the adherend 104 when the stamp 207 is peeled from the adherend 104, by forming the stamp 207 with an elastic body such as PDMS and providing holes at a plurality of positions from the central part to the edge part of the stamp 207.

(3) Third Embodiment

(3-1) Configuration and Operation

The formation flow of the adherend 104 shown in Fig. 1 to Fig. 5, Fig. 7 and Fig. 8, the block diagram of the transfer device 150 shown in Fig. 20, and the flowchart shown in Fig. 21 are employed also in a third embodiment. The third embodiment differs from the first embodiment in the structure of a stamp 307.

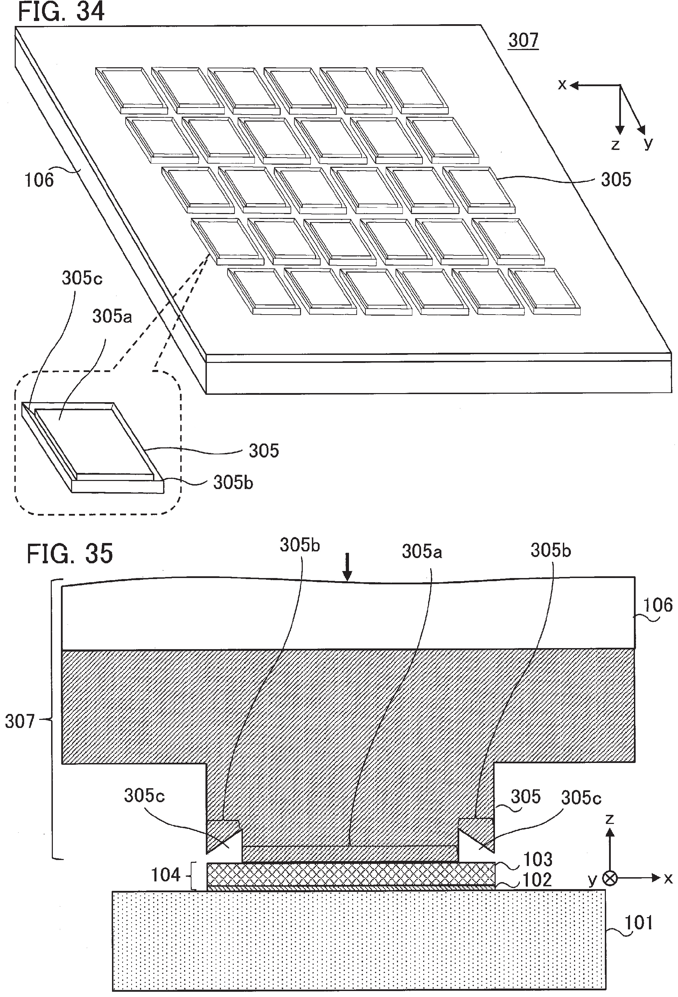

Fig. 34 is a schematic perspective view showing the stamp 307 as a transfer member used in a transfer method (manufacturing method of an electronic device) according to the third embodiment. The stamp 307 in Fig. 34 includes a plurality of joint members (elastic bodies) 305 formed at positions corresponding to the plurality of adherends 104 in Fig. 5 and a support 106 that supports the plurality of joint members 305. As shown in Fig. 34, the joint member 305 includes a first joint part 305a in a convex shape projecting in the -z direction (i.e., being high in the -z direction) and a second joint part 305b that is lower than the first joint part 305a. Namely, a concave part 305c is formed on the -z direction side of the second joint part 305b. The concave part 305c has an inclined surface that becomes shallower as the position becomes closer to an edge part. The joint member 305 is a part for picking up the adherend 104 as the semiconductor thin film. The material of the joint member 305 is the same as that in the first embodiment.

Fig. 35 is a schematic cross-sectional view showing a process of joining the first joint part 305a of the joint member 305 of the stamp 307 according to the third embodiment to the adherend 104. Fig. 35 shows a state in which the first joint part 305a of the joint member 305 has moved towards the adherend 104 and made contact with the adherend 104.

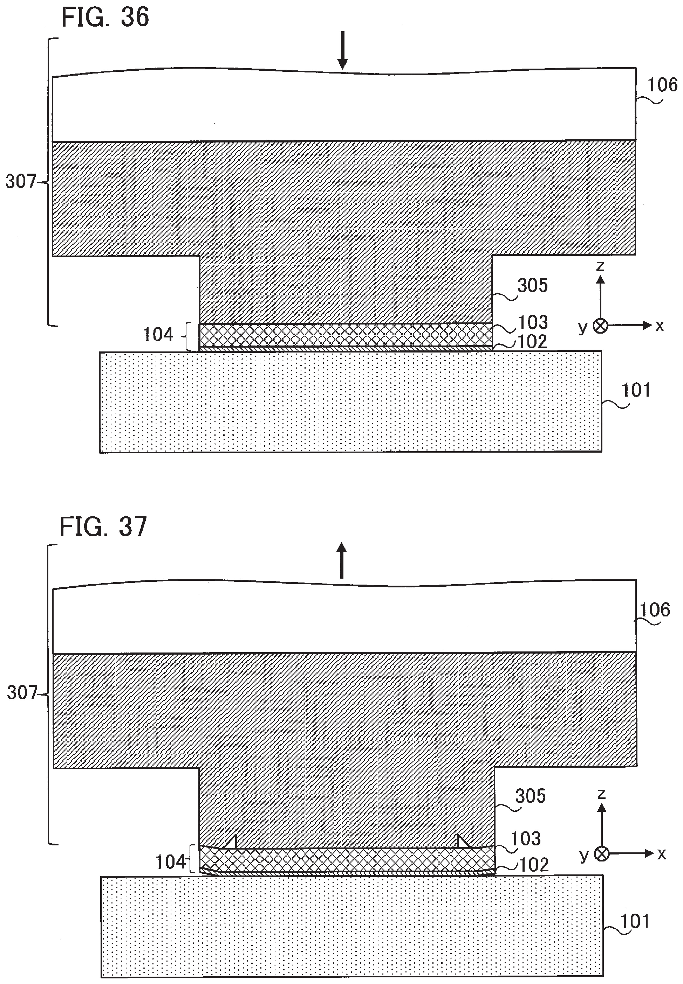

Fig. 36 is a schematic cross-sectional view showing a process of joining the second joint part 305b of the joint member 305 of the stamp 307 according to the third embodiment to the adherend 104. Fig. 36 is a diagram showing a state in which the joint member 305 has deformed and the second joint part 305b is in close contact with the adherend 104.

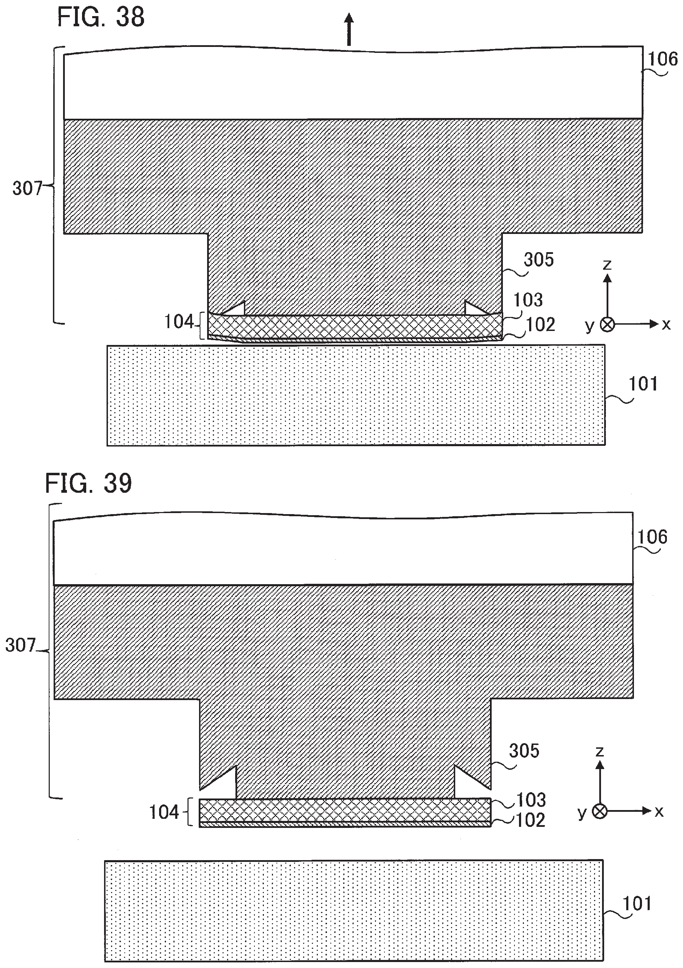

Figs. 37 to 39 are schematic cross-sectional views showing a process (part 1 - part 3) of moving the joint member 305 of the stamp 307 according to the third embodiment in the state of having been joined to the adherend 104. Fig. 37 shows a state when moving the stamp 307 upward (in the +z direction) is started. Fig. 38 shows a state when peeling the adherend 104 from the growth substrate 101 is started by moving the stamp 307 upward (in the +z direction). Fig. 39 shows a state when the joint member 305 has recovered to the original shape.

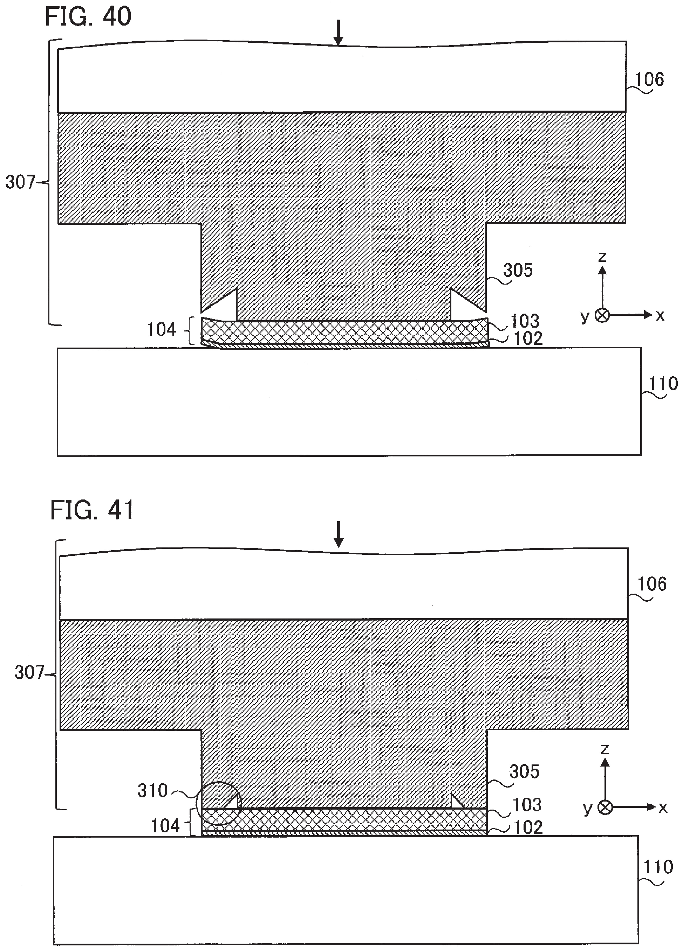

Fig. 40 and Fig. 41 are schematic cross-sectional views showing a process (part 1, part 2) of bonding the adherend 104 to the device substrate 110 (second base material) by using the stamp 307 according to the third embodiment. Fig. 40 shows a state when the adherend 104 is placed in contact with the device substrate 110. Fig. 41 shows a state in which the joint member 305 is deformed when the adherend 104 is stuck on the device substrate 110 by further applying a load from the state of Fig. 40.

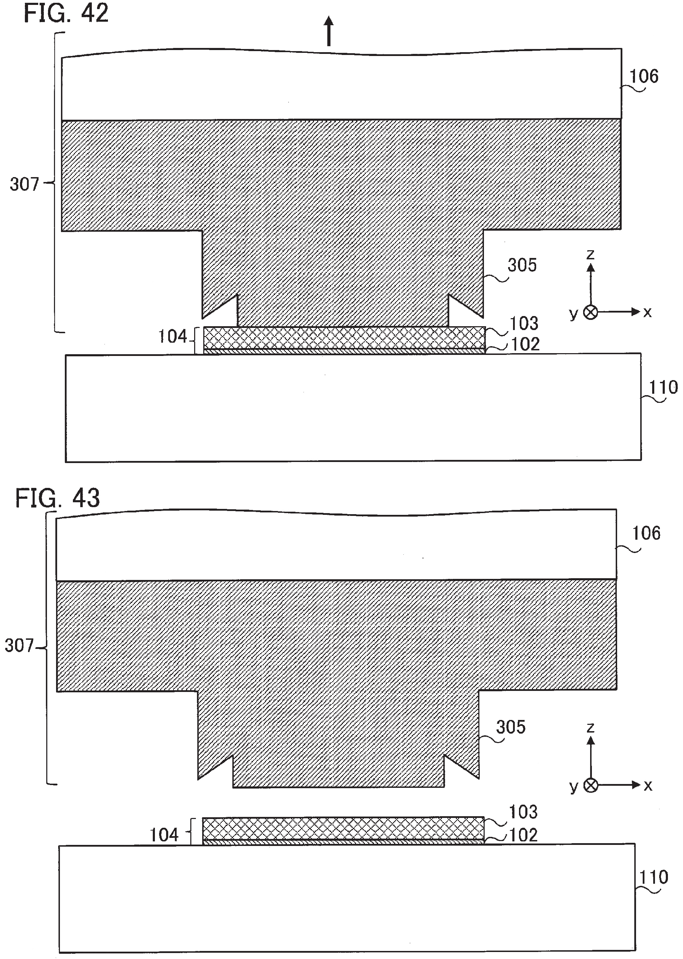

Fig. 42 and Fig. 43 are schematic cross-sectional views showing a process (part 1, part 2) of separating the stamp 307 according to the third embodiment from the adherend 104 bonded to the device substrate 110. Fig. 42 shows progress in which the stamp 307 after sticking the adherend 104 to the device substrate 110 is peeled from the adherend 104. Fig. 43 shows a state in which the stamp 307 after sticking the adherend 104 to the device substrate 110 has been separated from the adherend 104.

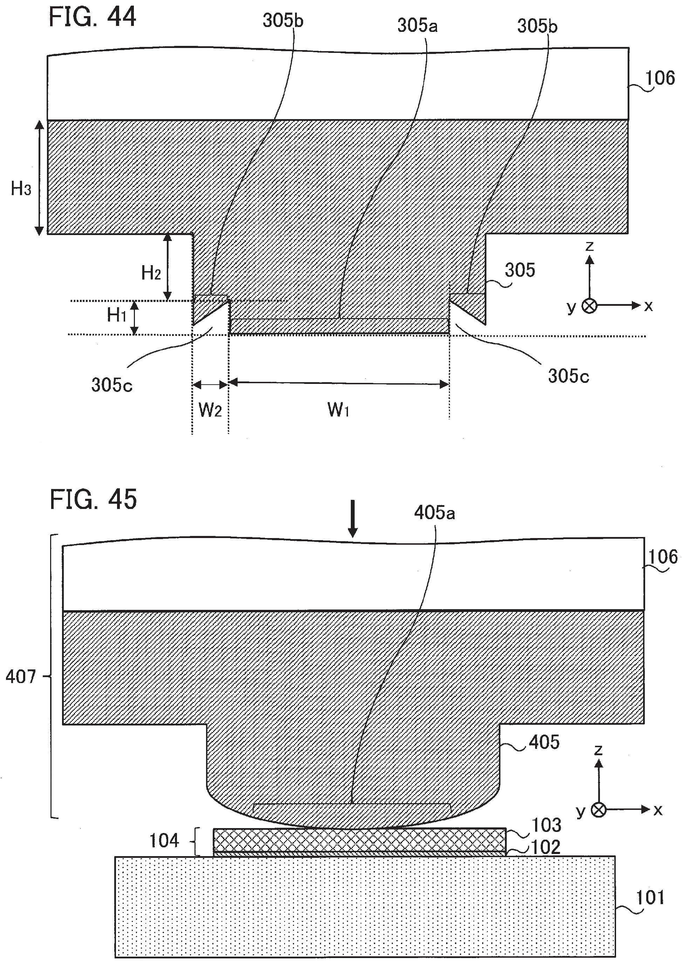

Fig. 44 is a schematic cross-sectional view showing the shape and dimensions of the joint member 305 of the stamp 307 according to the third embodiment.

In the third embodiment, first, as shown in Fig. 35, the stamp 307 formed with the joint member 305 and the support 106 is placed in contact with the adherend 104. Further, as shown in Fig. 36, the stamp 307 is moved downward (in the -z direction) until contact surfaces of the first joint part 305a and the second joint part 305b of the joint member 305 and the adherend 104 become parallel to each other. Similarly to the first embodiment, the contacting area of the joint member 305 and the adherend 104 in Fig. 35 is smaller than the contacting area of the joint member 305 and the adherend 104 in Fig. 36. The movement amount of moving the joint member 305 to elastically deform the joint member 305 and place the joint member 305 in perfect contact with the adherend 104 as shown in Fig. 36 is adjusted based on result of a previously performed experiment, and the stamp 307 is moved by the transfer device 150 storing the movement amount. The material of the joint member 305 is the same as that in the first embodiment.

Subsequently, as shown in Fig. 37, the stamp 307 is moved upward (in the +z direction). At that time, the joint member 305 that has been pressed from above and elastically deformed stops receiving the pressure from above and begins to recover to the original shape. In this case, since the edge part of the joint member 305 has been placed in contact with the adherend 104 thanks to the deformation and has joined to the adherend 104 with adhesive force, the adherend 104 peels from the growth substrate 101 starting from the edge part of the adherend 104. Incidentally, each drawing is a schematic diagram, in which objects are drawn with certain deformation. Thereafter, as shown in Fig. 38, the joint of the edge part of the joint member 305 to the adherend 104 is also peeled while the edge part of the adherend 104 is gradually peeled from the growth substrate 101 by deformation recovery due to its property; however, the peeling of the lower part of the adherend 104 and the growth substrate 101 is completed before the peeling of the edge part of the joint member 305.

Subsequently, as shown in Fig. 39, after the adherend 104 has peeled, the joint member 305 recovers to the original shape. For the adherend 104 that has been picked up, the first joint part 305a and the second joint part 305b of the joint member 305 of the stamp 307 recover to their original shapes and hold the adherend 104.

Subsequently, as shown in Fig. 40, the adherend 104 is transferred onto the device substrate 110 by using the stamp 307. Also at that time, the edge part of the joint member 305 is not in contact with the adherend 104, and thus the adherend 104 sticks to the device substrate 110 from the central part of the adherend 104. Further, as shown in Fig. 41, by applying downward force from above, the first joint part 305a and the second joint part 305b of the joint member 305 are deformed and pressed until making contact with the edge part of the adherend 104, by which also the edge part is placed in close contact with the device substrate 110. Similarly to the first embodiment, the contacting area of the joint member 305 and the adherend 104 in Fig. 40 is smaller than the contacting area of the joint member 305 and the adherend 104 in Fig. 41.

Lastly, as shown in Fig. 42, the stamp 307 is moved upward (in the +z direction) and the second joint part 305b of the joint member 305 gradually peels starting from the edge of the convex part. At that time, the edge part of the joint member 305 is situated on the inner side relative to the edge of the adherend 104, and thus the adherend 104 remains stable after the transfer, with no force applied thereto in the direction of peeling.

Finally, as shown in Fig. 43, the stamp 307 is separated and the transfer is finished. When the stamp 307 is separated, the second joint part 305b having the width $W_2$ shown in Fig. 44 (edge region 310 of the joint member 305 in Fig. 41) separates from the edge part in the state in which the first joint part 305a having the width $W_1$ is in contact with the adherend 104 in the adhering part (namely, in the state in which the adherend 104 is pressed by the first joint part 305a having the width $W_1$), and accordingly, the deformation recovery occurs and thereafter the part having the width $W_1$ also peels off.

As shown in Fig. 44, the relationship among the dimensions $H_1$, $H_2$, $W_1$ and $W_2$ of the joint member 305 is similar to that in the first embodiment. Further, it is desirable that the width of the first joint part 305a be narrower than the width of the adherend 104 and the total value of the width $W_1$ of the first joint part 305a and the widths $W_2$ of the two second joint parts 305b in the x direction or the y direction ($W_1 + 2 \cdot W_2$ in Fig. 44) be greater than or equal to the width of the adherend 104.

For the weight of the joint member 305, the adhesive force of the joint member 305 to the support 106 is sufficient, and thus the joint member 305 does not peel from the support 106 irrespective of the thickness of the joint member 305. Further, for the weight of the adherend 104, the adhesive force of the joint member 305 to the adherend 104 is sufficient, and thus the adherend 104 does not peel from the joint member 305 irrespective of the thickness of the adherend 104.

As described above, when peeling the adherend 104, the joint member 305 of the stamp 307 assumes the state in which the whole of the joint member 305 is deformed and making close contact with the adherend 104, and the peeling by weak force (less than or equal to 0.1 MPa) by the joint member 305 is performed on the entire upper surface of the adherend 104. At that time, the edge part of the adherend 104 is peeled without fail, and thereafter the joint member 305 elastically deformed gradually recovers to the original shape while pulling the adherend 104 upward with strong force, by which the whole of the adherend 104 is peeled in a stable manner.

The joining force between the adherend 104 and the growth substrate 101 after the part of the growth substrate 101 under the adherend 104 is removed is joining force sufficiently weaker than the adhesive force 0.1 MPa of PDMS. The joining force between the adherend 104 and the device substrate 110 is stronger than the joining force between the stamp 307 and the adherend 104, and is greater than or equal to 0.1 MPa.

As described above, the joint member 305 assumes the state in which the concave part has naturally peeled from the adherend 104 due to the elasticity of the convex part of the second joint part 305b of the joint member 305, and thereafter the stamp 307 is pulled upward, by which the stamp 307 can be peeled from the adherend 104 without causing the outer periphery of the joint member 305 to pull the adherend 104.

(3-2) Effect

As described above, according to the third embodiment, in addition to the effect of the first embodiment, the stamp 307 is formed with an elastic body such as PDMS and the concave part 305c is provided with the inclination. Accordingly, the adherend 104 gradually peels starting from the deep side to the shallow side of the concave part 305c when the adherend 104 peels from the second joint part 305b due to the deformation recovery of the first joint part 305a, by which the occurrence of cracking in the edge part of the adherend 104 due to stress can be inhibited.

(4) Fourth Embodiment

(4-1) Configuration and Operation

The formation flow of the adherend 104 shown in Fig. 1 to Fig. 5, Fig. 7 and Fig. 8, the block diagram of the transfer device 150 shown in Fig. 20, and the flowchart shown in Fig. 21 are employed also in a fourth embodiment. The fourth embodiment differs from the first embodiment in the structure of a stamp 407.

Fig. 45 is a schematic cross-sectional view showing a process of joining a first joint part 405a of a joint member 405 (elastic body) of a stamp 407 as a transfer member used in a transfer method (manufacturing method of an electronic device) according to the fourth embodiment to the adherend 104. Fig. 45 shows a state in which the stamp 407 formed with the joint member 405 and the support 106 is placed in contact with the adherend 104.

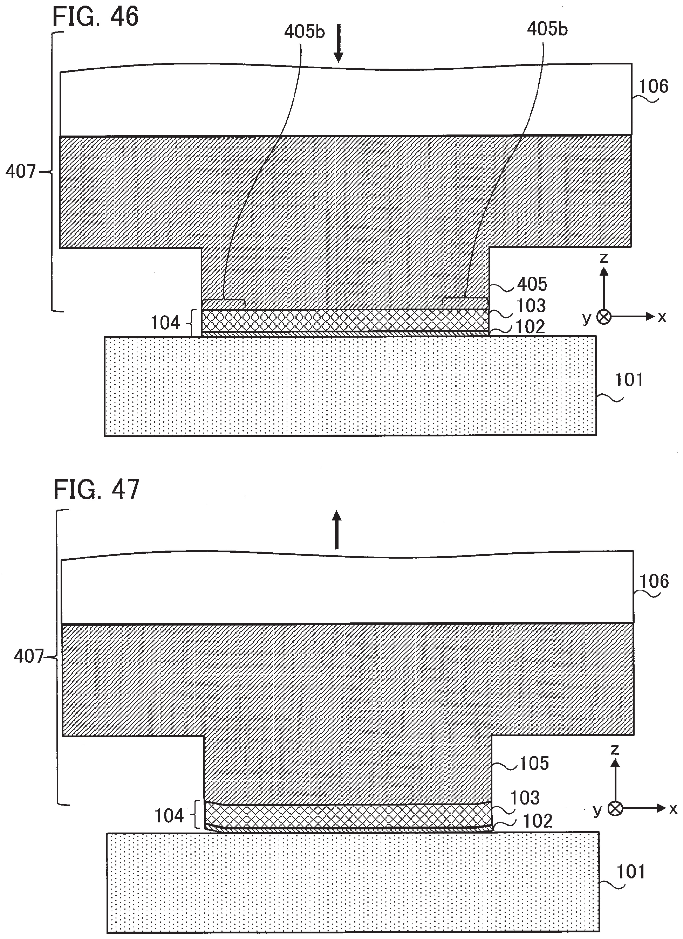

Fig. 46 is a schematic cross-sectional view showing a process of joining a second joint part 405b of the joint member 405 of the stamp 407 according to the fourth embodiment to the adherend 104. Fig. 46 shows a state in which the joint member 405 has deformed and is in close contact with the adherend 104.

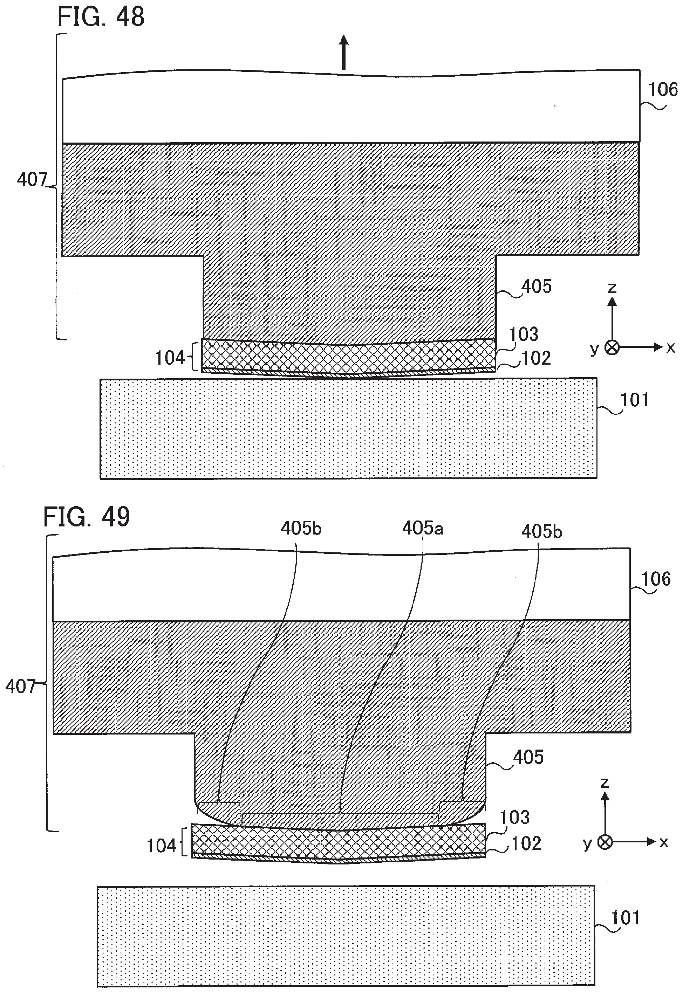

Figs. 47 to 49 are schematic cross-sectional views showing a process (part 1 - part 3) of moving the joint member 405 of the stamp 407 according to the fourth embodiment in the state of having been joined to the adherend 104. Fig. 47 shows a state when moving the stamp 407 upward (in the +z direction) is started. Fig. 48 shows a state when the adherend 104 has been peeled from the growth substrate 101 by moving the stamp 407 upward (in the +z direction). Fig. 49 shows a state when the joint member 405 has recovered to the original shape.

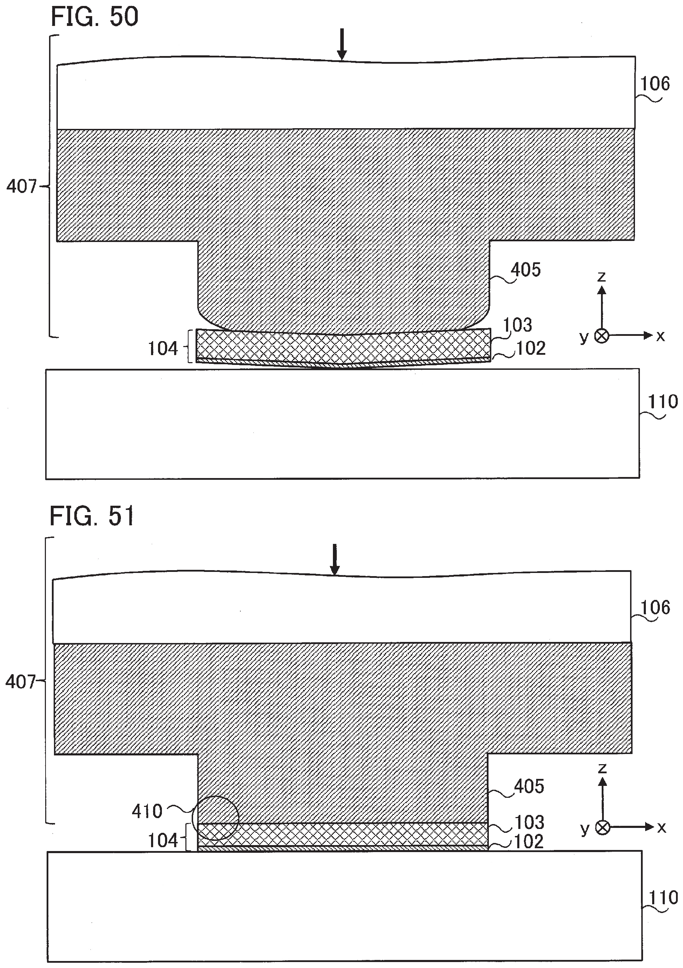

Fig. 50 and Fig. 51 are schematic cross-sectional views showing a process (part 1, part 2) of bonding the adherend 104 to the device substrate 110 by using the stamp 407 according to the fourth embodiment. Fig. 50 shows a state when the adherend 104 is placed in contact with the device substrate 110. Fig. 51 shows a state in which the joint member 405 is deformed when the adherend 104 is stuck on the device substrate 110 by further applying a load from the state of Fig. 50.

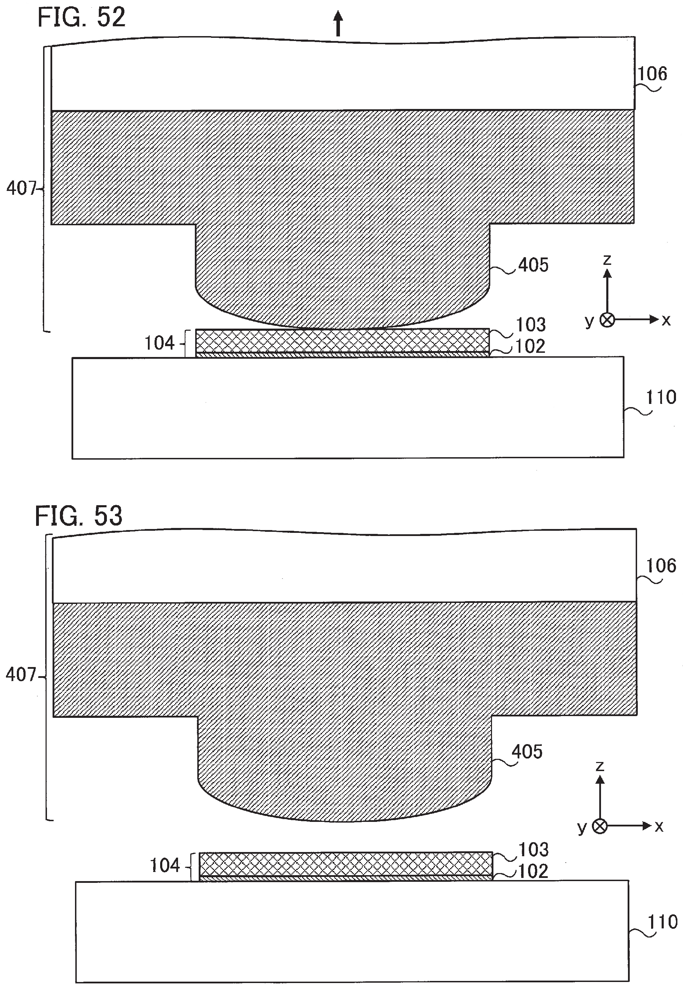

Fig. 52 and Fig. 53 are schematic cross-sectional views showing a process (part 1, part 2) of separating the stamp 407 according to the fourth embodiment from the adherend 104 bonded to the device substrate 110. Fig. 52 shows progress in which the stamp 407 after sticking the adherend 104 to the device substrate 110 is peeled from the adherend 104. Fig. 53 shows a state in which the stamp 407 after sticking the adherend 104 to the device substrate 110 has been separated from the adherend 104.

In the fourth embodiment, first, as shown in Fig. 45, the stamp 407 formed with the joint member 405 and the support 106 is placed in contact with the adherend 104. Further, as shown in Fig. 46, the stamp 407 is moved downward (in the -z direction) until the first joint part 405a and the second joint part 405b of the joint member 405 are elastically deformed and their contact surfaces with the adherend 104 become flat. Similarly to the first embodiment, the contacting area of the joint member 405 and the adherend 104 in Fig. 45 is smaller than the contacting area of the joint member 405 and the adherend 104 in Fig. 46. The movement amount of moving the joint member 405 to elastically deform the joint member 405 and place the joint member 405 in perfect contact with the adherend 104 as shown in Fig. 46 is adjusted based on a previously obtained experimental result, and the stamp 407 is operated by the transfer device 150 storing the movement amount. The material of the joint member 405 is the same as that in the first embodiment.

Subsequently, as shown in Fig. 47, the stamp 407 is moved upward (in the +z direction). At that time, the joint member 405 that has been pressed from above and elastically deformed stops receiving the pressure from above and begins to recover to the original shape. In this case, since the edge part of the joint member 405 has been placed in contact with the adherend 104 thanks to the deformation and has joined to the adherend 104 with adhesive force, the adherend 104 peels from the growth substrate 101 starting from the edge part of the adherend 104. Incidentally, each drawing is a schematic diagram, in which objects are drawn with certain deformation. Thereafter, as shown in Fig. 48, the joint of the edge part of the joint member 405 to the adherend 104 is also peeled while the edge part of the adherend 104 is peeled from the growth substrate 101 by deformation recovery due to its property; however, the peeling of the lower part of the adherend 104 and the growth substrate 101 is completed before the peeling of the edge part of the joint member 405.

Subsequently, as shown in Fig. 49, after the adherend 104 has peeled, the joint member 405 recovers towards the original shape. For the adherend 104 that has been picked up, the first joint part 405a and the second joint part 405b of the joint member 405 of the stamp 407 gradually recover to their original shapes and hold the adherend 104 in a state in which restitutive elastic force of the first joint part 405a, adhesive force of the first joint part 405a and rigidity of the adherend 104 are in equilibrium. At that time, the adherend 104 is held in a slightly warped state as shown in Fig. 49 since the base of the joint member 405 in the original shape is in a curved shape.

Subsequently, as shown in Fig. 50, the adherend 104 held by the stamp 407 is transferred onto the device substrate 110. At that time, the adherend 104 sticks to the device substrate 110 from the central part of the adherend 104 since the adherend 104 has slight warpage due to the joint member 405. Further, as shown in Fig. 51, by applying downward force from above, the first joint part 405a and the second joint part 405b of the joint member 405 are deformed and pressed until making contact with the edge part of the adherend 104, by which also the edge part is placed in close contact with the device substrate 110. Similarly to the first embodiment, the contacting area of the joint member 405 and the adherend 104 in Fig. 50 is smaller than the contacting area of the joint member 405 and the adherend 104 in Fig. 51.

Lastly, as shown in Fig. 52, the stamp 407 is moved upward (in the +z direction) and the joint member 405 gradually peels from the adherend 104 from the edge towards the center. Finally, as shown in Fig. 53, the stamp 407 is separated from the adherend 104 and the transfer is finished.

(4-2) Effect

As described above, the stamp 407 is formed with an elastic body such as PDMS and the first joint part 405a and the second joint part 405b are curved, by which the occurrence of cracking in the edge part of the adherend 104 due to stress can be inhibited both when the adherend 104 is peeled from the growth substrate 101 and when the stamp 407 is peeled from the adherend 104 bonded to the device substrate 110. Further, it becomes possible to carry out the transfer starting from the edge part at the time of peeling and starting from the central part at the time of sticking.

(5) Modifications

While PDMS is used as the joint member of the stamp in the first to fourth embodiments, a different material may also be used as long as the material is an elastic body and has viscosity. Further, also regarding the shape of the joint member of the stamp, a different shape may also be employed as long as the shape has a step (level difference) or the like in the edge part and the edge part of the shape of the elastic body before the deformation does not make contact with the adherend 104.

(6) Appendixes

In the following, various modes according to the present disclosure will be described together as appendixes.

(Appendix 1)

A transfer method for transferring an adherend situated on a first base material onto a second base material, comprising:

pressing a transfer member including a first joint part and a second joint part against the adherend situated on the first base material and thereby elastically deforming the first joint part and joining the first joint part and the second joint part to the adherend;
moving the transfer member to separate from the first base material and thereby separating the adherend from the first base material while leaving the first joint part and the second joint part joined to the adherend;
moving the transfer member to approach the second base material and thereby bonding the adherend to the second base material;
moving the transfer member to separate from the second base material and thereby separating the second joint part from the adherend while leaving the first joint part joined to the adherend; and
moving the transfer member to further separate from the second base material after the separation of the second joint part and thereby separating the first joint part from the adherend.

(Appendix 2)

The transfer method according to appendix 1, wherein moving speed of the transfer member when the transfer member is moved to separate from the first base material is faster than the moving speed of the transfer member when the transfer member is moved to separate from the second base material.

(Appendix 3)

The transfer method according to appendix 1 or 2, wherein

a width of the first joint part is narrower than a width of the adherend, and
a total value of the width of the first joint part and width of the second joint part is greater than or equal to the width of the adherend.

(Appendix 4)

The transfer method according to any one of appendixes 1 to 3, wherein a contacting area of the transfer member and the adherend when the first joint part and the second joint part have been joined to the adherend is larger than the contacting area of the transfer member and the adherend when the transfer member is moved to separate from the second base material after the separation of the second joint part.

(Appendix 5)

A manufacturing method of an electronic device, comprising:

pressing a transfer member including a first joint part and a second joint part against an adherend situated on a first base material and thereby elastically deforming the first joint part and joining the first joint part and the second joint part to the adherend;
moving the transfer member to separate from the first base material and thereby separating the adherend from the first base material while leaving the first joint part and the second joint part joined to the adherend;
moving the transfer member to approach a second base material and thereby bonding the adherend to the second base material;
moving the transfer member to separate from the second base material and thereby separating the second joint part from the adherend while leaving the first joint part joined to the adherend; and
moving the transfer member to further separate from the second base material after the separation of the second joint part and thereby separating the first joint part from the adherend while providing the adherend on the second base material.

(Appendix 6)

The manufacturing method of an electronic device according to appendix 5, wherein moving speed of the transfer member when the transfer member is moved to separate from the first base material is faster than the moving speed of the transfer member when the transfer member is moved to separate from the second base material.

(Appendix 7)

The manufacturing method of an electronic device according to appendix 5 or 6, wherein

a width of the first joint part is narrower than a width of the adherend, and
a total value of the width of the first joint part and width of the second joint part is greater than or equal to the width of the adherend.

(Appendix 8)

The manufacturing method of an electronic device according to any one of appendixes 5 to 7, wherein a contacting area of the transfer member and the adherend when the first joint part and the second joint part have been joined to the adherend is larger than the contacting area of the transfer member and the adherend when the transfer member is moved to separate from the second base material after the separation of the second joint part.

(Appendix 9)

A transfer member comprising a joint member that is pressed against an adherend and thereby joined to the adherend, wherein
the joint member includes:

a first joint part capable of joining to the adherend; and
a second joint part capable of joining to the adherend when the first joint part has joined to the adherend,
wherein the joint member is configured so that the first joint part and the second joint part join to the adherend when the first joint part is pressed against the adherend and elastically deformed and the second joint part separates from the adherend when the pressing is removed and the first joint part recovers.

(Appendix 10)

The transfer member according to appendix 9, further comprising a support that supports the joint member, wherein height of the first joint part is greater than height of the second joint part in a first direction heading for the adherend from the support.

(Appendix 11)

The transfer member according to appendix 10, wherein the second joint part includes a concave part whose depth direction is the first direction.

(Appendix 12)

The transfer member according to any one of appendixes 9 to 11, wherein the second joint part is provided on an edge part's side of the first joint part.

(Appendix 13)

The transfer member according to appendix 10 or 11, wherein the support is harder than the joint

(Appendix 14)

The transfer member according to any one of appendixes 9 to 13, wherein
a width of the second joint part is greater than or equal to half of height of the first joint part and is smaller than or equal to 1.5 times width of the first joint part.

(Appendix 15)

The transfer member according to any one of appendixes 9 to 13, wherein
a width of the first joint part is greater than or equal to height of the first joint part.

(Appendix 16)

The transfer member according to any one of appendixes 9 to 13, wherein
a total value of width of the first joint part and width of the second joint part is greater than or equal to a value obtained by subtracting height of the first joint part from height of the joint member including the first joint part and the second joint part.

(Appendix 17)

The transfer member according to any one of appendixes 9 to 13, wherein
height of the joint member including the first joint part and the second joint part is greater than or equal to twice height of the first joint part and is smaller than or equal to 20 times the height of the first joint part.

(Appendix 18)

The transfer member according to any one of appendixes 9 to 17, wherein

the transfer member satisfies a conditional expression (A1), and
the second joint part is separated from the adherend when the pressing is removed and the first joint part is deformed,

$$a_1 > A \cdot H / (E \cdot H_1 + A \cdot H) \qquad (A1)$$

where

$a_1$ denotes a contacting area of the first joint part and the adherend,
A denotes adhesive force of the joint member,
E denotes Young's modulus of the joint member,
$H_1$ denotes height of the first joint part, and
H denotes height of the joint member.

(Appendix 19)

The transfer member according to any one of appendixes 9 to 17, wherein

the transfer member satisfies a conditional expression (A2), and
the second joint part is separated from the adherend when the pressing is removed and the first joint part is deformed,

$$a_2 < E \cdot H_1 / (E \cdot H_1 + A \cdot H) \qquad (A2)$$

where

$a_2$ denotes a contacting area of the second joint part and the adherend,
A denotes adhesive force of the joint member,
E denotes Young's modulus of the joint member,
$H_1$ denotes height of the first joint part, and
H denotes height of the joint member.

(6) Description of Reference Characters

101: growth substrate (first base material), 104: functional unit (adherend), 105, 205, 305, 405: joint member (elastic body), 105a, 205a, 305a, 405a: first joint part, 105b, 205b, 305b, 405b: second joint part, 105c: concave part (step part), 205c, 305c: concave part, 106: support, 107, 207, 307, 407: stamp (transfer member), 110: device substrate (second base material).

**Claims**

1. A transfer method for transferring an adherend situated on a first base material onto a second base material, comprising:

pressing a transfer member including a first joint part and a second joint part against the adherend situated on the first base material and thereby elastically deforming the first joint part and joining the first joint part and the second joint part to the adherend;
moving the transfer member to separate from the first base material and thereby separating the adherend from the first base material while leaving the first joint part and the second joint part joined to the adherend;
moving the transfer member to approach the second base material and thereby bonding the adherend to the second base material;
moving the transfer member to separate from the second base material and thereby separating the second joint part from the adherend while leaving the first joint part joined to the adherend; and
moving the transfer member to further separate from the second base material after the separation of the second

18

joint part and thereby separating the first joint part from the adherend.

2. The transfer method according to claim 1, wherein moving speed of the transfer member when the transfer member is moved to separate from the first base material is faster than the moving speed of the transfer member when the transfer member is moved to separate from the second base material.

3. The transfer method according to claim 1 or 2, wherein

   a width of the first joint part is narrower than a width of the adherend, and
   a total value of the width of the first joint part and width of the second joint part is greater than or equal to the width of the adherend.

4. The transfer method according to claim 1 or 2, wherein a contacting area of the transfer member and the adherend when the first joint part and the second joint part have been joined to the adherend is larger than the contacting area of the transfer member and the adherend when the transfer member is moved to separate from the second base material after the separation of the second joint part.

5. A manufacturing method of an electronic device, comprising:

   pressing a transfer member including a first joint part and a second joint part against an adherend situated on a first base material and thereby elastically deforming the first joint part and joining the first joint part and the second joint part to the adherend;
   moving the transfer member to separate from the first base material and thereby separating the adherend from the first base material while leaving the first joint part and the second joint part joined to the adherend;
   moving the transfer member to approach a second base material and thereby bonding the adherend to the second base material;
   moving the transfer member to separate from the second base material and thereby separating the second joint part from the adherend while leaving the first joint part joined to the adherend; and
   moving the transfer member to further separate from the second base material after the separation of the second joint part and thereby separating the first joint part from the adherend while providing the adherend on the second base material.

6. The manufacturing method of an electronic device according to claim 5, wherein moving speed of the transfer member when the transfer member is moved to separate from the first base material is faster than the moving speed of the transfer member when the transfer member is moved to separate from the second base material.

7. The manufacturing method of an electronic device according to claim 5 or 6, wherein

   a width of the first joint part is narrower than a width of the adherend, and
   a total value of the width of the first joint part and width of the second joint part is greater than or equal to the width of the adherend.

8. The manufacturing method of an electronic device according to claim 5 or 6, wherein a contacting area of the transfer member and the adherend when the first joint part and the second joint part have been joined to the adherend is larger than the contacting area of the transfer member and the adherend when the transfer member is moved to separate from the second base material after the separation of the second joint part.

9. A transfer member comprising a joint member that is pressed against an adherend and thereby joined to the adherend, wherein
   the joint member includes:

   a first joint part capable of joining to the adherend; and
   a second joint part capable of joining to the adherend when the first joint part has joined to the adherend, wherein the joint member is configured so that the first joint part and the second joint part join to the adherend when the first joint part is pressed against the adherend and elastically deformed and the second joint part separates from the adherend when the pressing is removed and the first joint part recovers.

10. The transfer member according to claim 9, further comprising a support that supports the joint member,

wherein height of the first joint part is greater than height of the second joint part in a first direction heading for the adherend from the support.

11. The transfer member according to claim 10, wherein the second joint part includes a concave part whose depth direction is the first direction.

12. The transfer member according to any one of claims 9 to 11, wherein the second joint part is provided on an edge part's side of the first joint part.

13. The transfer member according to claim 10 or 11, wherein the support is harder than the joint member.

## FIG. 1

101

z
y⊗ →x

## FIG. 2(A)

103
102
101

z
y⊗ →x

## FIG. 2(B)

103

y
z⊙ →x

FIG. 3(A)

FIG. 3(B)

FIG. 4

ADHEREND
(COMPOSITE
INTEGRATED
FILM) 104

ELECTRODE

WIRING LAYER    WIRING LAYER

z
y
x

FIG. 5

103

101

y
z    x

## FIG. 6

## FIG. 7

## FIG. 8

FIG. 9

FIG. 10

FIG. 11

106

107

105

103
102

104

101

z
y ⊗ → x

FIG. 12

106

107

105

103
102

104

101

z
y ⊗ → x

FIG. 13

FIG. 14

FIG. 15

FIG. 16

FIG. 17

FIG. 18

FIG. 19(A)

FIG. 19(B)

FIG. 20

FIG. 21

START

FORM ADHEREND ON FIRST BASE MATERIAL (GROWTH
SUBSTRATE)
ETCH PART OF FIRST BASE MATERIAL UNDER ADHEREND — ST11

PRESS STAMP (TRANSFER MEMBER) AGAINST ADHEREND
(FIRST JOINT PART AND SECOND JOINT PART ARE JOINED TO
ADHEREND) — ST12

SEPARATE ADHEREND FROM FIRST BASE MATERIAL
BY LIFTING STAMP — ST13

BOND ADHEREND TO SECOND BASE MATERIAL (DEVICE
SUBSTRATE) BY MAKING STAMP PRESS ADHEREND AGAINST
SECOND BASE MATERIAL — ST14

MOVE STAMP UPWARD, LET FIRST JOINT PART RECOVER, AND
SEPARATE SECOND JOINT PART FROM ADHEREND — ST15

SEPARATE FIRST JOINT PART FROM ADHEREND
BY MOVING STAMP UPWARD — ST16

END

## FIG. 22

## FIG. 23

FIG. 24

FIG. 25

FIG. 26

FIG. 27

## FIG. 28

## FIG. 29

FIG. 30

FIG. 31

FIG. 32

106

207

205

z
y⊗ → x

103
104
102

110

FIG. 33

205b  205a 205b  205a  205b  205a  205b

106

$H_3$

$H_2$

205

$H_1$

205c

z
y⊗ → x

$W_2$  $W_1$  $2W_2$  $W_1$  $2W_2$  $W_1$  $W_2$

FIG. 34

FIG. 35

FIG. 36

FIG. 37

FIG. 38

FIG. 39

FIG. 40

FIG. 41

## FIG. 42

## FIG. 43

FIG. 44

FIG. 45

FIG. 46

FIG. 47

FIG. 48

FIG. 49

FIG. 50

FIG. 51

FIG. 52

106

407

405

z
y ⊗ → x

103
104 — 102

110

FIG. 53

106

407

405

z
y ⊗ → x

103
104 — 102

110

# EP 4 787 421 A1

<table>
<tr><td colspan="2">INTERNATIONAL SEARCH REPORT</td><td>International application No.<br><br>**PCT/JP2024/031965**</td></tr>
</table>

**A. CLASSIFICATION OF SUBJECT MATTER**

*H01L 21/02*(2006.01)i; *G09F 9/00*(2006.01)i; *H01L 21/50*(2006.01)i; *H01L 21/52*(2006.01)i; *H01L 21/60*(2006.01)i; *H01L 21/677*(2006.01)i; *H10H 20/00*(2025.01)i

FI: H01L21/02 B; G09F9/00 338; H01L21/50 C; H01L21/52 C; H01L21/60 311T; H01L21/68 A; H01L33/00 H

According to International Patent Classification (IPC) or to both national classification and IPC

**B. FIELDS SEARCHED**

Minimum documentation searched (classification system followed by classification symbols)

H01L21/02; H01L21/50-21/52; H01L21/58; H01L21/60-21/607; H01L21/67-21/687; H01L33/00-33/64; G09F9/00-9/33

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | CN 112967989 A (CHONGQING KONKA OPTOELECTRONIC TECHNOLOGY RESEARCH INSTITUTE CO., LTD.) 15 June 2021 (2021-06-15) paragraphs [0048]-[0089], fig. 1-27 | 1-12 |
| Y | | 13 |
| Y | JP 2020-129638 A (SHIN-ETSU CHEMICAL CO., LTD.) 27 August 2020 (2020-08-27) paragraphs [0096]-[0121], [0132]-[0157], fig. 4-6, 8-9 | 13 |
| Y | US 2023/0059174 A1 (X-CELEPRINT LIMITED) 23 February 2023 (2023-02-23) paragraphs [0038]-[0081], fig. 1A-10C | 13 |
| Y | US 2010/0123268 A1 (MENARD, Etienne) 20 May 2010 (2010-05-20) paragraphs [0062]-[0064], fig. 1-3 | 13 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **21 October 2024** | **05 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/031965**

| Patent document cited in search report | | | Publication date (day/month/year) | Patent family member(s) | | | Publication date (day/month/year) |
|---|---|---|---|---|---|---|---|
| CN | 112967989 | A | 15 June 2021 | (Family: none) | | | |
| JP | 2020-129638 | A | 27 August 2020 | US | 2022/0124949 | A1 | |
| | | | | paragraphs [0172]-[0208], [0220]-[0245], fig. 4-6, 8-9 | | | |
| | | | | WO | 2020/166184 | A1 | |
| | | | | EP | 3926695 | A1 | |
| | | | | CN | 113396485 | A | |
| | | | | KR | 10-2021-0125492 | A | |
| | | | | TW | 202032691 | A | |
| US | 2023/0059174 | A1 | 23 February 2023 | (Family: none) | | | |
| US | 2010/0123268 | A1 | 20 May 2010 | WO | 2010/059781 | A1 | |
| | | | | KR | 10-2011-0118616 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022079295 A